# EUROPEAN PATENT APPLICATION

(11) **EP 4 780 178 A1**
(43) Date of publication of application: **22.07.2026**
(21) Application number: 25224132.8
(22) Date of filing: 16.12.2025
(51) Int. Cl.: H10K 59/122, H10K 59/80

(54) **DISPLAY DEVICE AND ELECTRONIC DEVICE**

(30) Priority: 15.01.2025 KR 20250005839
(71) Applicant: Samsung Display Co., Ltd., Yongin-si, Gyeonggi-do 17113 (KR)
(72) Inventor: KIM, Jin Taek, Yongin-si (KR); PARK, Sang Ho, Yongin-si (KR); SON, Yong Duck, Yongin-si (KR); JUNG, Hwa Youn, Yongin-si (KR); CHOI, Byeong Kyun, Yongin-si (KR); TAE, Seung Gyu, Yongin-si (KR)
(74) Representative: Marks & Clerk LLP

(57) **Abstract**

Disclosed herein are a display device in which the aperture ratio of pixels can increased, and an electronic device, the display device including a substrate, a first electrode above the substrate, a pixel-defining layer above the first electrode and defining an emission area in which the first electrode is exposed, a separator above the pixel-defining layer, an emission unit above the first electrode, the pixel-defining layer, and the separator, and a second electrode above the emission unit and including a base electrode above the emission unit, and a protruding electrode protruding from the base electrode toward the emission unit.

## Description

### BACKGROUND

### 1. Field

The present disclosure relates to a display device in which the aperture ratio of pixels can be increased, and an electronic device.

### 2. Description of the Related Art

An organic light-emitting display apparatus includes display elements having luminance varying depending on electric current, for example, organic light-emitting diodes.

### SUMMARY

Aspects of the present disclosure provide a display device in which the aperture ratio of pixels can increased, and an electronic device.

According to an aspect of the present disclosure, there is provided a display device including a substrate, a first electrode above the substrate, a pixel-defining layer above the first electrode and defining an emission area in which the first electrode is exposed, a separator above the pixel-defining layer, an emission unit above the first electrode, the pixel-defining layer, and the separator, and a second electrode above the emission unit and including a base electrode above the emission unit, and a protruding electrode protruding from the base electrode toward the emission unit.

The emission unit may have a depressed shape by the protruding electrode.

The protruding electrode may protrude toward the separator overlapping with the emission unit.

The protruding electrode may have a width that gradually decreases in a direction from the base electrode toward the separator.

The protruding electrode may have a triangular cross-section.

The protruding electrode may have a sharp end protruding toward the emission unit.

The protruding electrode may protrude toward the emission unit in an auxiliary emission area where the pixel-defining layer and the base electrode overlap each other.

The auxiliary emission area may surround the emission area in plan view.

The emission unit may include a hole injection layer above the first electrode and the pixel-defining layer, wherein a distance between the protruding electrode and the hole injection layer above the pixel-defining layer in the auxiliary emission area is less than a distance between the base electrode and the hole injection layer above the first electrode in the emission area.

The separator may have a thickness of about 10 nm to about 100 nm, and includes a first bank above the pixel-defining layer, a second bank above the first bank, and a third bank above the second bank and having a width that is greater than that of the second bank, and wherein a sum of thicknesses of the first bank, the second bank, and the third bank ranges from about 10 nm to about 100 nm.

The emission unit may include an electron transport layer including an organic molecule, and hydrogen bonded to the organic molecule.

According to another aspect of the present disclosure, there is provided a display device including a substrate, a first electrode above the substrate, a pixel-defining layer above the first electrode and defining an emission area in which the first electrode is exposed, a separator penetrating the pixel-defining layer, an emission unit above the first electrode, the pixel-defining layer, and the separator, and a second electrode above the emission unit and including a base electrode above the emission unit, and a protruding electrode protruding from the base electrode toward the emission unit.

The protruding electrode may protrude toward the emission unit in an auxiliary emission area where the pixel-defining layer and the base electrode overlap each other.

The emission unit may have a depressed shape by the protruding electrode.

The protruding electrode may protrude toward the separator overlapping with the emission unit, and has a width that gradually decreases in a direction from the base electrode toward the separator.

The protruding electrode may have a triangular cross-section.

The protruding electrode may have a sharp end protruding toward the emission unit.

The separator may have a width of about 80 nm to about 200 nm.

According to still another aspect of the present disclosure, there is provided an electronic device including a display device for providing a display screen and including a substrate, a first electrode above the substrate, a pixel-defining layer above the first electrode and defining an emission area in which the first electrode is exposed, a separator above the pixel-defining layer, an emission unit above the first electrode, the pixel-defining layer, and the separator, and a second electrode above the emission unit and including a base electrode above the emission unit, and a protruding electrode protruding from the base electrode toward the emission unit.

The electronic device may by a smartphone, a tablet PC, a laptop computer, a TV, a desktop monitor, smart glasses, a smart watch, a head-mounted display, or a display for vehicles.

At least some of the above and other features of the invention are set out in the claims.

The details of one or more embodiments of the subject matter described in this specification are set forth in the accompanying drawings and the description below.

According to one or more embodiments, the aperture ratio of pixels can be increased.

For example, a protruding electrode of a second electrode may have a sharp shape, and the distance between the second electrode and a hole injection layer in an auxiliary emission area is reduced by the protruding electrode, so that electric field can be concentrated and increased in the auxiliary emission area. Accordingly, the amount of light emitted by an emission unit in the auxiliary emission area can increase, which can in turn increase the aperture ratio of the pixels.

The aspects of the present disclosure are not limited to the above-described effects and other aspects that are not described herein will become apparent to those skilled in the art from the following description.

### BRIEF DESCRIPTION OF THE DRAWINGS

The above and other aspects of the present disclosure will become more apparent by describing in detail embodiments thereof with reference to the attached drawings, in which:
FIG. 1 is an exploded, perspective view of a display device according to one or more embodiments of the present disclosure.
FIG. 2 is a block diagram showing a display device according to one or mor embodiments of the present disclosure.
FIG. 3 is an equivalent circuit diagram of a first sub-pixel according to one or more embodiments of the present disclosure.
FIG. 4 is a view showing an example of a layout of a display panel according to one or more embodiments of the present disclosure.
FIGS. 5 and 6 are views showing examples of the layout of the display area of FIG. 4.
FIG. 7 is a cross-sectional view showing an example of the display panel taken along line l1 - l1' of FIG. 5.
FIG. 8 is a cross-sectional view showing area A1 of FIG. 7 in detail.
FIG. 9 is a block diagram of the emission unit of FIG. 7.
FIG. 10 is a view showing a layout of a display area according to one or more other embodiments.
FIG. 11 is a cross-sectional view showing an example of the display panel, taken along line l2 - l2' of FIG. 10.
FIG. 12 is a cross-sectional view showing area A2 of FIG. 11 in detail.
FIG. 13 is a block diagram of the emission unit of FIG. 11.
FIG. 14 is an image of a cross section of a display device according to one or more embodiments.
FIG. 15 is an image of a cross section of a display device according to one or more embodiments.
FIG. 16 is a block diagram of an electronic device according to one or more embodiments of the present disclosure.
FIGS. 17, 18, and 19 are views showing electronic devices according to a variety of embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions, such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions, such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

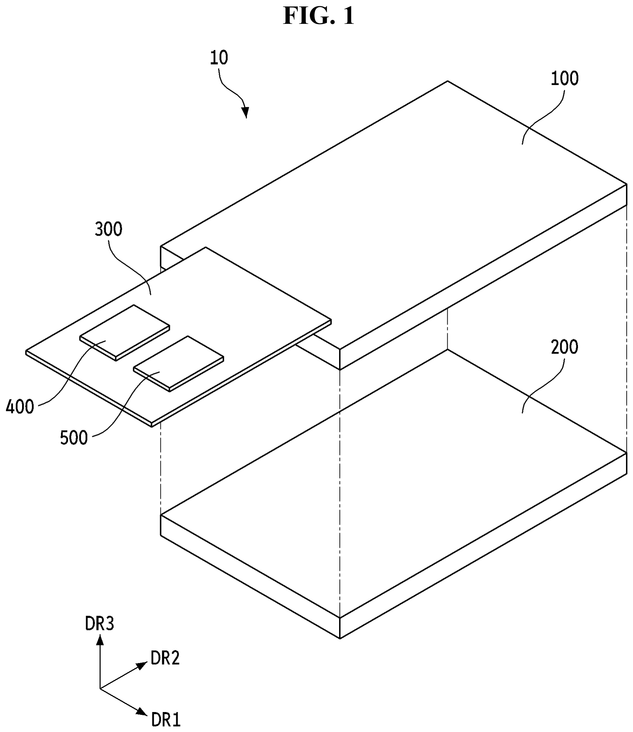

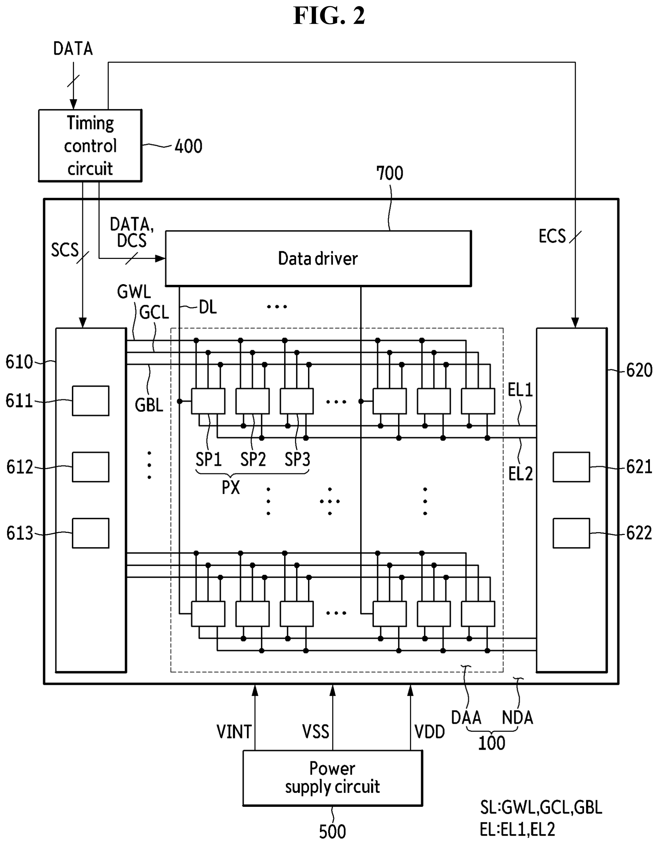

FIG. 1 is an exploded, perspective view of a display device according to one or more embodiments of the present disclosure. FIG. 2 is a block diagram showing a display device according to one or more embodiments of the present disclosure.

Referring to FIGS. 1 and 2, the display device 10 displays a moving image or a still image. The display device 10 may be employed by portable electronic devices, such as a mobile phone, a smart phone, a tablet PC, a mobile communications terminal, an electronic notebook, an electronic book, a portable multimedia player (PMP), a navigation device and an ultra mobile PC (UMPC). For example, the display device 10 of the present disclosure may be used as a display unit of a television, a laptop computer, a monitor, an electronic billboard, or the Internet of Things (IOT). Alternatively, the display device 10 of the present disclosure may be applied to a smart watch, a watch phone, or a head-mounted display (HMD) for implementing virtual reality and augmented reality.

The display device 10 includes a display panel 100, a heat dissipation layer 200, a circuit board 300, a timing control circuit 400, and a power supply circuit 500.

The display panel 100 may have a shape similarly to a rectangular shape when viewed from the top. For example, the display panel 100 may have a shape similar to a rectangle having shorter sides in the first direction DR1 and longer sides in the second direction DR2 crossing the first direction DR1 when viewed from the top. In the display panel 100, the corners where the shorter sides in the first direction DR1 meet the longer sides in the second direction DR2 may be rounded with a curvature (e.g., predetermined curvature) or may be a right angle. The shape of the display panel 100 when viewed from the top is not limited to a rectangular shape, but may be formed in a shape similar to other polygonal shapes, a circular shape, or an elliptical shape. The shape of the display device 10 may follow the shape of the display panel 100 when viewed from the top (e.g., in plan view), but the embodiments of the present disclosure are not limited thereto.

The display panel 100 includes a plurality of pixels PX, a plurality of scan lines SL, a plurality of emission control lines EL, a plurality of data lines DL, a scan driver 610, an emission driver 620, and a data driver 700. The display panel 100 may be divided into a display area DAA where images are displayed, and a non-display area NDA where no image is displayed, as shown in FIG. 2.

The plurality of pixels PX may be located in the display area DAA. The pixels PX may be arranged in a matrix in the first direction DR1 and the second direction DR2. The scan lines SL and the emission control lines EL may be extended in the first direction DR1 and may be arranged in the second direction DR2. The data lines DL may be extended in the second direction DR2 and may be arranged in the first direction DR1.

The plurality of scan lines SL includes a plurality of write scan lines GWL, a plurality of control scan lines GCL, and a plurality of bias scan lines GBL. The plurality of emission control lines EL includes a plurality of first emission control lines EL1 and a plurality of second emission control lines EL2.

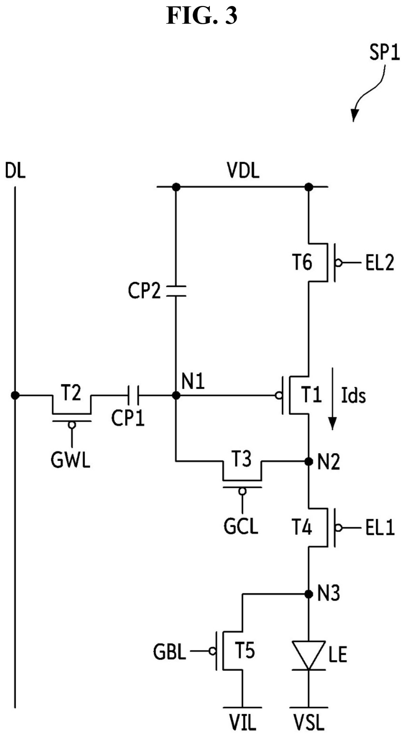

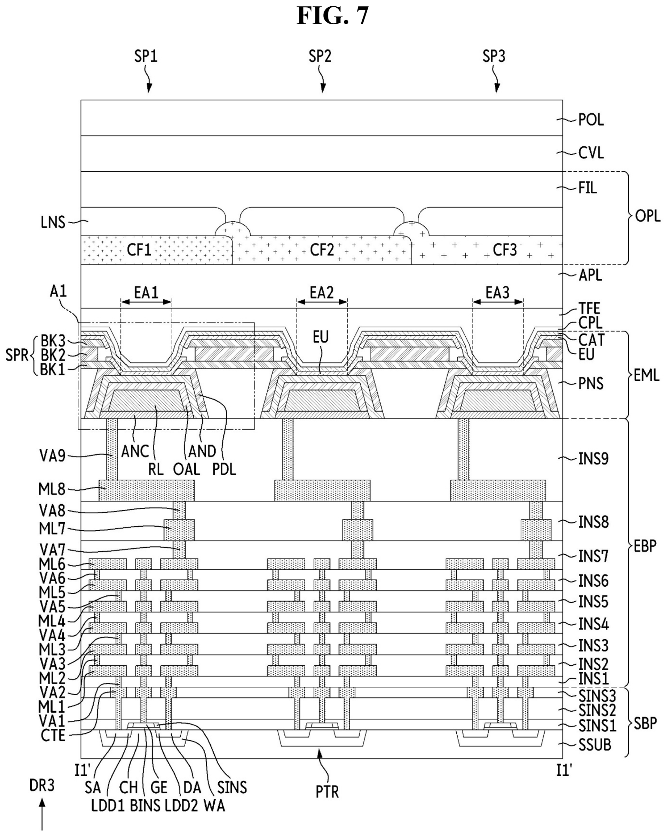

The plurality of pixels PX includes a plurality of sub-pixels SP1, SP2, and SP3. The plurality of sub-pixels SP1, SP2, and SP3 includes a plurality of pixel transistors as shown in FIG. 3. The pixel transistors are formed via a semiconductor process and may be located on a semiconductor substrate SSUB (see FIG. 7). For example, the pixel transistors may be implemented as complementary metal oxide semiconductor (CMOS). It should be understood, however, that the embodiments of the present disclosure are not limited thereto.

Each of the sub-pixels SP1, SP2, and SP3 may be connected to one of the write scan lines GWL, one of the control scan lines GCL, one of the bias scan lines GBL, one of the first emission control lines EL1, one of the second emission control lines EL2, and one of the data lines DL. Each of the sub-pixels SP1, SP2, and SP3 may receive the data voltage from the data line DL according to the write scan signal from the write scan line GWL, and may allow the light-emitting elements to emit light according to the data voltage.

The scan driver 610, the emission driver 620, and the data driver 700 may be located in the non-display area NDA.

The scan driver 610 includes a plurality of scan transistors, and the emission driver 620 includes a plurality of light-emitting transistors. A plurality of scan transistors and a plurality of light-emitting transistors are formed via a semiconductor process and may be formed on the semiconductor substrate SSUB (see FIG. 7). For example, a plurality of scan transistors and a plurality of light-emitting transistors may be formed of CMOS. It should be understood, however, that the embodiments of the present disclosure are not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan-timing control signal SCS from the timing control circuit 400. The write scan signal output unit 611 may generate write scan signals according to the scan-timing control signal SCS from the timing control circuit 400 and sequentially output them to the write scan lines GWL. The control scan signal output unit 612 may generate control scan signals according to the scan-timing control signal SCS and sequentially output them to the control scan lines GCL. The bias scan signal output unit 613 may generate bias scan signals according to the scan-timing control signal SCS and sequentially output them to the bias scan lines GBL.

The emission driver 620 includes a first emission control driver 621 and a second emission control driver 622. Each of the first emission control driver 621 and the second emission control driver 622 may receive an emission-timing control signal ECS from the timing control circuit 400. The first emission control driver 621 may generate first emission control signals according to the emission-timing control signal ECS and sequentially output them to the first emission control lines EL1. The second emission control driver 622 may generate second emission control signals according to the emission-timing control signal ECS and sequentially output them to the second emission control lines EL2.

The data driver 700 may include a plurality of data transistors, and the plurality of data transistors may be formed via a semiconductor process and may be formed on the semiconductor substrate SSUB (see FIG. 7). For example, a plurality of data transistors may be formed of CMOS transistors. It should be understood, however, that the embodiments of the present disclosure are not limited thereto.

The data driver 700 may receive digital video data DATA and a data-timing control signal DCS from the timing control circuit 400. The data driver 700 converts the digital video data DATA into analog data voltages according to the data-timing control signal DCS and outputs them to the data lines DL. In doing so, the sub-pixels SP1, SP2, and SP3 are selected by the write scan signal of the scan driver 610, and data voltages may be applied to the selected sub-pixels SP1, SP2, and SP3.

The heat dissipation layer 200 may overlap with the display panel 100 in the third direction DR3, which is the thickness direction of the display panel 100. The heat dissipation layer 200 may be located on one surface of the display panel 100 (e.g., on the rear surface). The heat dissipation layer 200 serves to release heat generated in the display panel 100. The heat dissipation layer 200 may include a metal layer, such as graphite, silver (Ag), copper (Cu), and/or aluminium (Al) having a high thermal conductivity.

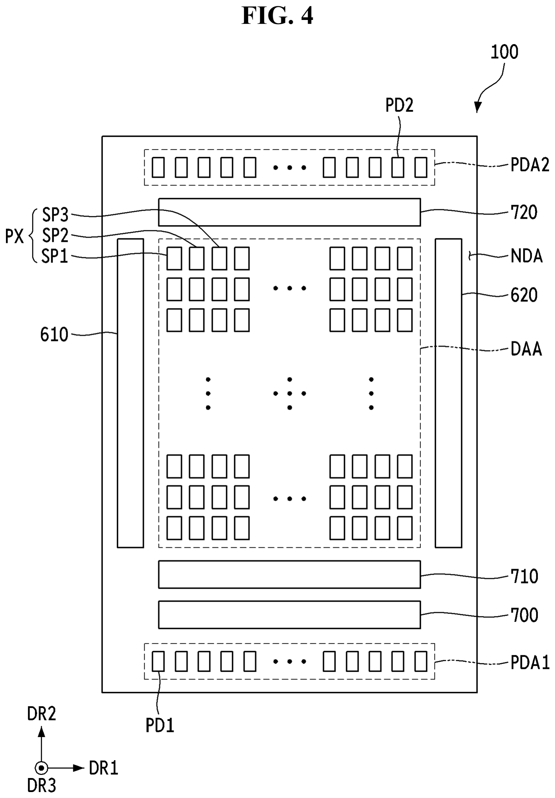

The circuit board 300 may be electrically connected to a plurality of first pads PD1 (see FIG. 4) of a first pad area PDA1 (see FIG. 4) of the display panel 100 using a conductive adhesive member, such as an anisotropic conductive film. The circuit board 300 may be a flexible printed circuit board made of a flexible material, or a flexible film. Although the circuit board 300 is unfolded in the example shown in FIG. 1, the circuit board 300 may be bent. When the circuit board 300 is bent, one end of the circuit board 300 may be located on the rear surface of the display panel 100 and/or the rear surface of the heat dissipation layer 200. The other end of the circuit board 300 may be connected to a plurality of first pads PD1 (see FIG. 4) of the first pad area PDA1 (see FIG. 4) of the display panel 100 using a conductive adhesive material. One end of the circuit board 300 may be opposite to the other end of the circuit board 300.

The timing control circuit 400 may receive digital video data and timing signals from the outside. The timing control circuit 400 may generate a scan-timing control signal SCS, an emission-timing control signal ECS, and a data-timing control signal DCS for controlling the display panel 100 in response to the timing signals. The timing control circuit 400 may output the scan-timing control signal SCS to the scan driver 610 and output the emission-timing control signal ECS to the emission driver 620. The timing control circuit 400 may output the digital video data and the data-timing control signal DCS to the data driver 700.

A power supply circuit 500 may generate a plurality of panel driving voltages in response to a supply voltage from the outside. For example, the power supply circuit 500 may generate a first supply voltage VSS, a second supply voltage VDD, and a third supply voltage VINT to apply them to the display panel 100. The first supply voltage VSS, the second supply voltage VDD, and the third supply voltage VINT will be described later with reference to FIG. 3.

Each of the timing control circuit 400 and the power supply circuit 500 may be implemented as an integrated circuit (IC) and attached to a surface of the circuit board 300. The scan-timing control signal SCS, the emission-timing control signal ECS, the digital video data DATA, and the data-timing control signal DCS from the timing control circuit 400 may be supplied to the display panel 100 through the circuit board 300. The first supply voltage VSS, the second supply voltage VDD, and the third supply voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the scan driver 610, the emission driver 620, and the data driver 700. In this instance, the timing control circuit 400 may include a plurality of timing transistors, and each power supply circuit 500 may include a plurality of power transistors. A plurality of timing transistors and a plurality of power transistors may be formed via a semiconductor process and may be formed on the semiconductor substrate SSUB (see FIG. 7). For example, the plurality of timing transistors and the plurality of power transistors may be formed of CMOS transistors. It should be understood, however, that the embodiments of the present disclosure are not limited thereto. Each of the timing control circuit 400 and the power supply circuit 500 may be located between the data driver 700 and the first pad area PDA1 (see FIG. 4).

FIG. 3 is an equivalent circuit diagram of a first sub-pixel according to one or more embodiments of the present disclosure.

Referring to FIG. 3, a first sub-pixel SP1 may be connected to a write scan line GWL, a control scan line GCL, a bias scan line GBL, a first emission control line EL1, a second emission control line EL2, and a data line DL. In addition, the first sub-pixel SP1 may be connected to a first supply voltage line VSL where the first supply voltage VSS, which is equal to a low-level voltage, is applied, a second supply voltage line VDL where the second supply voltage VDD, which is equal to a high-level voltage, is applied, and a third supply voltage line VIL where the third supply voltage VINT, which is equal to an initialization voltage, is applied. In other words, the first supply voltage line VSL may be a low-level voltage line, the second supply voltage line VDL may be a high-level voltage line, and the third supply voltage line VIL may be an initialization voltage line. The first supply voltage VSS may be lower than the third supply voltage VINT. The second supply voltage VDD may be higher than the third supply voltage VINT.

The first sub-pixel SP1 includes a plurality of transistors T1 to T6, a light-emitting element LE, a first capacitor CP1, and a second capacitor CP2.

The light-emitting element LE emits light according to a driving current Ids flowing in a channel of the first transistor T1. The amount of the light emitted from the light-emitting element LE may be proportional to the driving current Ids. The light-emitting element LE may be located between the fourth transistor T4 and the first supply voltage line VSL. The first electrode of the light-emitting element LE may be connected to a drain electrode of the fourth transistor T4, and the second electrode thereof may be connected to the first supply voltage line VSL. The first electrode of the light-emitting element LE may be an anode electrode, and the second electrode of the light-emitting element LE may be a cathode electrode. The light-emitting element LE may be an organic light-emitting diode including a first electrode, a second electrode, and an organic light-emitting layer located between the first electrode and the second electrode. It should be understood, however, that the present disclosure is not limited thereto. For example, the light-emitting element LE may be an inorganic light-emitting element including a first electrode, a second electrode, and an inorganic semiconductor located between the first electrode and the second electrode. In this instance, the light-emitting element LE may be a micro light-emitting diode.

The first transistor T1 may be a driving transistor for controlling the source-drain current Ids (hereinafter referred to as "driving current") flowing between the source electrode and the drain electrode according to the voltage applied to the gate electrode. The first transistor T1 includes a gate electrode connected to a first node N1, a source electrode connected to a drain electrode of the sixth transistor T6, and a drain electrode connected to a second node N2.

The second transistor T2 may be located between one electrode of the first capacitor CP1 and the data line DL. The second transistor T2 is turned on by a write scan signal from the write scan line GWL and connects the electrode of the first capacitor CP1 to the data line DL. Accordingly, the data voltage of the data line DL may be applied to the electrode of the first capacitor CP1. The second transistor T2 includes a gate electrode connected to the write scan line GWL, a source electrode connected to the data line DL, and a drain electrode connected to the electrode of the first capacitor CP1.

A third transistor T3 may be located between the first node N1 and the second node N2. The third transistor T3 is turned on by the control scan signal of the control scan line GCL and connects the first node N1 to the second node N2. Accordingly, if the gate electrode and source electrode of the first transistor T1 are connected with each other, the first transistor T1 may act like a diode. The third transistor T3 includes a gate electrode connected to the control scan line GCL, a source electrode connected to the second node N2, and a drain electrode connected to the first node N1.

The fourth transistor T4 may be connected between the second node N2 and a third node N3. The fourth transistor T4 is turned on by a first emission control signal of the first emission control line EL1 and connects the second node N2 to the third node N3. Accordingly, the driving current of the first transistor T1 may be supplied to the light-emitting element LE. The fourth transistor T4 includes a gate electrode connected to the first emission control line EL1, a source electrode connected to the second node N2, and a drain electrode connected to the third node N3.

The fifth transistor T5 may be located between the third node N3 and the third supply voltage line VIL. The fifth transistor T5 is turned on by a bias scan signal of the bias scan line GBL and connects the third node N3 to the third supply voltage line VIL. Accordingly, the third supply voltage VINT of the third supply voltage line VIL may be applied to the first electrode of the light-emitting element LE. The fifth transistor T5 includes a gate electrode connected to the bias scan line GBL, a source electrode connected to the third node N3, and a drain electrode connected to the third driving voltage line VIL.

The sixth transistor T6 may be located between the source electrode of the first transistor T1 and the second supply voltage line VDL. The sixth transistor T6 is turned on by the second emission control signal of the second emission control line EL2 and connects the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor CP1 is formed between the first node N1 and the drain electrode of the second transistor T2. The first capacitor CP1 includes a first electrode connected to the drain electrode of the second transistor T2, and a second electrode connected to the first node N1.

The second capacitor CP2 is formed between the gate electrode of the first transistor T1 and the second driving voltage line VDL. The second capacitor CP2 includes a first electrode connected to the gate electrode of the first transistor T1 and a second electrode connected to the second driving voltage line VDL.

The first node N1 is a contact point where the gate electrode of the first transistor T1, the drain electrode of the third transistor T3, the second electrode of the first capacitor CP1, and the first electrode of the second capacitor CP2 meet. The second node N2 is a contact point where the drain electrode of the first transistor T1, the source electrode of the third transistor T3, and the source electrode of the fourth transistor T4 meet. The third node N3 is a contact point where the drain electrode of the fourth transistor T4, the source electrode of the fifth transistor T5, and the first electrode of the light-emitting element LE meet.

Each of the first to sixth transistors T1 to T6 may be a metal-oxide-semiconductor field effect transistor (MOSFET). For example, each of the first to sixth transistors T1 to T6 may be, but is not limited to, a p-type MOSFET. Each of the first to sixth transistors T1 to T6 may be an n-type MOSFET. Alternatively, some of the first to sixth transistors T1 to T6 may be p-type MOSFETs, and the other transistors may be n-type MOSFETs.

Although the first sub-pixel SP1 includes the six transistors T1 to T6 and the two capacitors C1 and C2 in the example shown in FIG. 3, it should be noted that the equivalent circuit diagram of the first sub-pixel SP1 is not limited to that shown in FIG. 3. For example, the numbers of the transistors and the capacitors of the first sub-pixel SP1 are not limited to those shown in FIG. 3.

In addition, the equivalent circuit diagram of the second sub-pixel SP2 and the equivalent circuit diagram of the third sub-pixel SP3 may be substantially identical to the equivalent circuit diagram of the first sub-pixel SP1 described above with reference to FIG. 3. Therefore, the redundant descriptions will be omitted.

FIG. 4 is a view showing an example of a layout of a display panel according to one or more embodiments of the present disclosure.

Referring to FIG. 4, the display area DAA of the display panel 100 includes a plurality of pixels PX arranged in a matrix. The non-display area NDA of the display panel 100 includes the scan driver 610, the emission driver 620, the data driver 700, a first distribution circuit 710, a second distribution circuit 720, a first pad area PDA1, and a second pad area PDA2.

The scan driver 610 may be located on a first side of the display area DAA, and the emission driver 620 may be located on a second side of the display area DAA. For example, the scan driver 610 may be located on one side of the display area DAA in the first direction DR1, and the emission driver 620 may be located on the opposite side of the display area DAA in the first direction DR1. For example, the scan driver 610 may be located on the left side of the display area DAA, and the emission driver 620 may be located on the right side of the display area DAA. It should be understood, however, that the embodiments of the present disclosure are not limited thereto. The scan driver 610 and the emission driver 620 may be located on both the first and second sides of the display area DAA.

The first pad area PDA1 may include a plurality of first pads PD1 connected to pads or bumps of the circuit board 300 through a conductive adhesive member. The first pad area PDA1 may be located on a third side of the display area DAA. For example, the first pad area PDA1 may be located on one side of the display area DAA in the second direction DR2. The first pad area PDA1 may be located on the outer side of the data driver 700 in the second direction DR2. That is to say, the first pad area PDA1 may be located closer to the edge of the display panel 100 than the data driver 700 is.

The second pad area PDA2 may include a plurality of second pads PD2, which are test pads for testing whether the display panel 100 operates normally. The plurality of second pads PD2 may be connected to a jig or a probe pin during a test process, or may be connected to a circuit board for testing. The circuit board for testing may be a printed circuit board made of a rigid material or a flexible printed circuit board made of a flexible material.

The second pad area PDA2 may be located on a fourth side of the display area DAA. For example, the second pad area PDA2 may be located on the opposite side of the display area DAA in the second direction DR2. The second pad area PDA2 may be located on the outer side of the second distribution circuit 720 in the second direction DR2. That is to say, the second pad area PDA2 may be located closer to the edge of the display panel 100 than the second distribution circuit 720.

The first distribution circuit 710 distributes data voltages applied via the first pad area PDA1 to a plurality of data lines DL. For example, the first distribution circuit 710 may divide the data voltages applied via one first pad PD1 of the first pad area PDA1 into P data lines DL, thereby reducing the number of the plurality of first pads PD1, where P is a positive integer equal to or greater than two. The first distribution circuit 710 may be located on the third side of the display area DAA of the display panel 100. For example, the first distribution circuit 710 may be located on one side of the display area DAA in the second direction DR2. That is to say, the first distribution circuit 710 may be located on the lower side of the display area DAA.

The second distribution circuit 720 distributes signals applied through the second pad area PDA2 to the scan driver 610, the emission driver 620, and the data lines DL. The second pad area PDA2 and the second distribution circuit 720 may be elements to assess the operation of each of the pixels PX in the display area DAA. The second distribution circuit 720 may be located on a fourth side of the display area DAA of the display panel 100. For example, the second distribution circuit 720 may be located on the opposite side of the display area DAA in the second direction DR2. That is to say, the second distribution circuit 720 may be located on the upper side of the display area DAA.

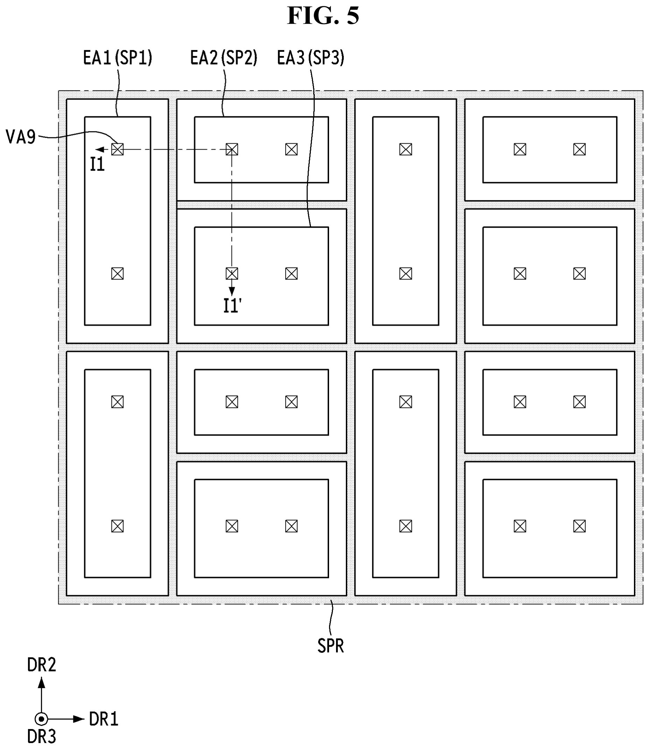

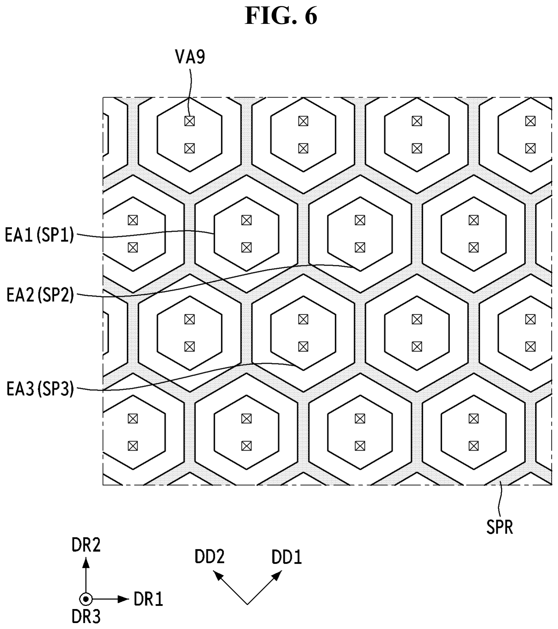

FIGS. 5 and 6 are views showing examples of the layout of the display area of FIG. 4.

Referring to FIGS. 5 and 6, each of the plurality of pixels PX includes a first emission area EA1 that is the emission area of the first sub-pixel SP1, a second emission area EA2 that is the emission area of the second sub-pixel SP2, and a third emission area EA3 that is the emission area of the third sub-pixel SP3.

Each of the first emission area EA1, the second emission area EA2, and the third emission area EA3 may have a polygonal shape, a circular shape, an elliptical shape, or an irregular shape when viewed from the top.

The maximum length of the first emission area EA1 in the first direction DR1 may be less than the maximum length of the second emission area EA2 in the first direction DR1 and the maximum length of the third emission area EA3 in the first direction DR1. The maximum length of the second emission area EA2 in the first direction DR1 may be substantially equal to the maximum length of the third emission area EA3 in the first direction DR1.

The maximum length of the first emission area EA1 in the second direction DR2 may be greater than the maximum length of the second emission area EA2 in the second direction DR2 and the maximum length of the third emission area EA3 in the second direction DR2. The maximum length of the second emission area EA2 in the second direction DR2 may be less than the maximum length of the third emission area EA3 in the second direction DR2. The maximum length of the first emission area EA1 in the second direction DR2 may be greater than the maximum length of the second emission area EA2 in the second direction DR2.

The first emission area EA1, the second emission area EA2, and the third emission area EA3 may have a hexagonal shape consisting of six straight lines as shown in FIG. 6 when viewed from the top. It should be understood, however, that the embodiments of the present disclosure are not limited thereto. The first emission area EA1, the second emission area EA2, and the third emission area EA3 may have a polygonal shape other than a hexagon, a circular shape, an elliptical shape, or an irregular shape when viewed from the top.

As shown in FIG. 5, in each of the plurality of pixels PX, the first emission area EA1 and the second emission area EA2 may be adjacent to each other in the first direction DR1. In addition, the first emission area EA1 and the third emission area EA3 may be adjacent to each other in the first direction DR1. In addition, the second emission area EA2 and the third emission area EA3 may be adjacent to each other in the second direction DR2. The first emission area EA1, the second emission area EA2, and the third emission area EA3 may have different respective areas.

Alternatively, as shown in FIG. 6, the first emission area EA1 and the second emission area EA2 may be adjacent to each other in the first direction DR1, the second emission area EA2 and the third emission area EA3 may be adjacent to each other in a first diagonal direction DD1, and the first emission area EA1 and the third emission area EA3 may be adjacent to each other in a second diagonal direction DD2. The first diagonal direction DD1 refers to a direction between the first direction DR1 and the second direction DR2, and refers to a direction inclined by 45 degrees relative to the first direction DR1 and the second direction DR2. The second diagonal direction DD2 may be orthogonal to the first diagonal direction DD1.

The first sub-pixel SP1 may output the first light that has passed through the first color filter CF1 (see FIG. 7) from among the light output from the first emission area EA1, the second sub-pixel SP2 may output the second light that has passed through the second color filter CF2 (see FIG. 7) from among the light output from the second emission area EA2, and the third sub-pixel SP3 may output the third light that has passed through the third color filter CF3 (see FIG. 7) from among the light output from the third emission area EA3.

The first light, the second light, and the third light described above may be light of different respective wavelength ranges. For example, among the first to third light, one light may be light in a blue wavelength range, another light may be light in a green wavelength range, and the other light may be light in a red wavelength range. The blue wavelength range may refer that the main peak wavelength of light lies in the wavelength range of approximately 370 nm to approximately 480 nm, the green wavelength range may refer that the main peak wavelength of light lies in the wavelength range of approximately 480 nm to approximately 560 nm, and the red wavelength range may refer to that the main peak wavelength of light lies in the wavelength range of approximately 600 nm to approximately 750 nm.

Although each of the plurality of pixels PX includes three emission areas EA1, EA2, and EA3 in the example shown in FIGS. 5 and 6, the embodiments of the present disclosure are not limited thereto. For example, each of the plurality of pixels PX may include four emission areas.

In addition, the layout of the emission areas of the plurality of pixels PX is not limited to that shown in FIGS. 5 and 6. For example, the emission areas of the plurality of pixels PX may have a stripe structure in which the emission areas are arranged in the first direction DR1, a PenTile^{®} matrix (PenTile^{®} being a registered trademark of Samsung Display Co., Ltd., Republic of Korea) in which the emission areas have a diamond arrangement, or a hexagonal structure in which emission areas having a hexagonal shape when viewed from the top are arranged as shown in FIG. 6.

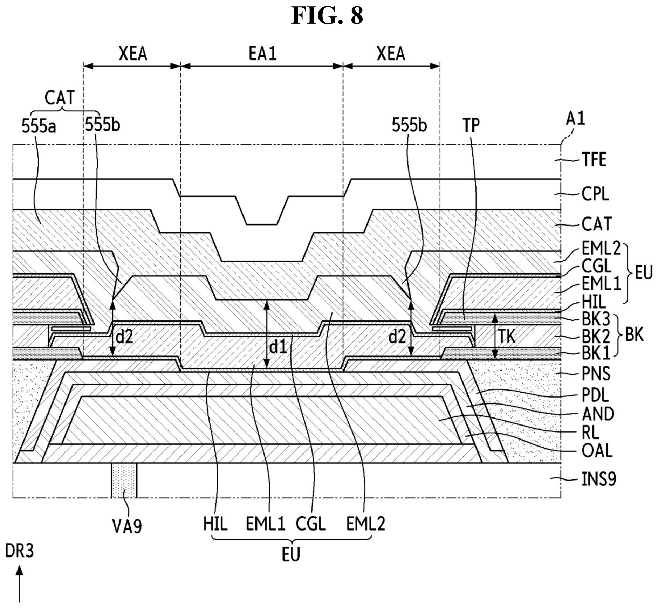

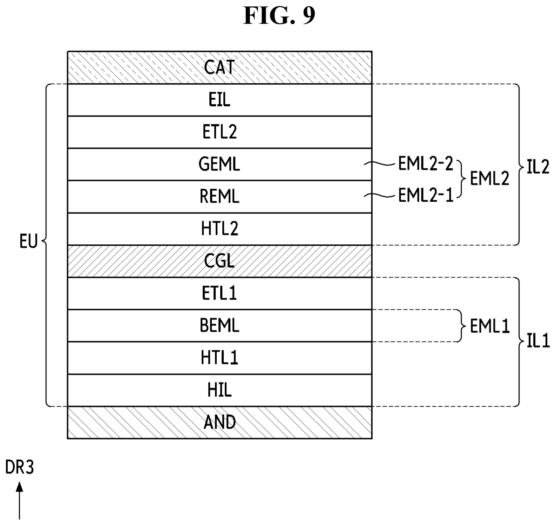

FIG. 7 is a cross-sectional view showing an example of the display panel taken along line l1 - l1' of FIG. 5. FIG. 8 is a cross-sectional view showing area A1 of FIG. 7 in detail. FIG. 9 is a block diagram of the emission unit EU of FIG. 7.

Referring to FIGS. 7 and 8, the display panel 100 includes a semiconductor backplane SBP, a light-emitting element backplane EBP, a display element layer EML, an encapsulation layer TFE, an optical layer OPL, a cover layer CVL, and a polarizer POL.

The semiconductor backplane SBP includes a semiconductor substrate SSUB including a plurality of pixel transistors PTR, a plurality of semiconductor insulating layers covering the plurality of pixel transistors PTR, and a plurality of contact terminals CTE that are electrically connected to the pixel transistors PTR, respectively. The plurality of pixel transistors PTR may be the first to sixth transistors T1 to T6 described above with reference to FIG. 4.

The semiconductor substrate SSUB may be a silicon substrate, a germanium substrate, or a silicon-germanium substrate. The semiconductor substrate SSUB may be a substrate doped with first-type impurities. A plurality of well areas WA may be arranged in the upper surface of the semiconductor substrate SSUB. The well areas WA may be doped with second-type impurities. The second-type impurities may be different from the first-type impurities. For example, when the first-type impurities are p-type impurities, the second-type impurities may be n-type impurities. Alternatively, when the first-type impurities are n-type impurities, the second-type impurities may be p-type impurities.

Each of the well areas WA includes a source region SA associated with a source electrode of a pixel transistor PTR, a drain region DA associated with a drain electrode thereof, and a channel region CH between the source region SA and the drain region DA.

A bottom insulating layer BINS may be located between the gate electrode GE and the well areas WA. Side insulating layers SINS may be located on the side surfaces of the gate electrode GE. The side insulating layers SINS may be located on the bottom insulating layer BINS.

Each of the source region SA and the drain region DA may be doped with the first-type impurities. The gate electrode GE of the pixel transistor PTR may overlap with the well area WA in the third direction DR3 which is the thickness direction of the semiconductor substrate SSUB. The channel region CH may overlap with the gate electrode GE in the third direction DR3. The source region SA may be located on one side of the gate electrode GE, and the drain region DA may be located on the opposite side of the gate electrode GE.

Each of the plurality of well areas WA may further include a first low-concentration impurity region LDD1 located between the channel region CH and the source region SA, and a second low-concentration impurity region LDD2 located between the channel region CH and the drain region DA. The first low-concentration impurity region LDD1 may have a lower impurity concentration than the source region SA due to the bottom insulating layer BINS. The second low-concentration impurity region LDD2 may have a lower impurity concentration than the drain region DA due to the bottom insulating layer BINS. The distance between the source region SA and the drain region DA may be increased by the first low-concentration impurity region LDD1 and the second low-concentration impurity region LDD2. Therefore, the length of the channel region CH of each of the pixel transistors PTR can be increased, and thus it is possible to reduce or prevent punch-through and hot carrier phenomenon due to short channel.

A first semiconductor insulating layer SINS1 may be located on the semiconductor substrate SSUB. The first semiconductor insulating layer SINS1 may be formed of, but is not limited to, a silicon carbon nitride (SiCN)- or a silicon oxide (SiOx)-based inorganic film.

A second semiconductor insulating layer SINS2 may be located on the first semiconductor insulating layer SINS1. The second semiconductor insulating layer SINS2 may be formed of a silicon oxide (SiOx)-based inorganic film, but the embodiments of the present disclosure are not limited thereto.

A plurality of contact terminals CTE may be located on the second semiconductor insulating layer SINS2. Each of the plurality of contact terminals CTE may be connected to one of the gate electrode GE, the source region SA, or the drain region DA of each of the pixel transistors PTR through a hole penetrating the first semiconductor insulating layer SINS1 and the second semiconductor insulating layer SINS2. The contact terminals CTE may be made of one of copper (Cu), aluminium (Al), tungsten (W), molybdenum (Mo), chromium (Cr), gold (Au), titanium (Ti), nickel (Ni), or neodymium (Nd), or an alloy containing one of these.

A third semiconductor insulating layer SINS3 may be located on the side surface of each of the contact terminals CTE. The upper surface of each of the contact terminals CTE may not be covered by the third semiconductor insulating layer SINS3 but may be exposed. The third semiconductor insulating layer SINS3 may be formed of a silicon oxide (SiOx)-based inorganic film, but the embodiments of the present disclosure are not limited thereto.

The semiconductor substrate SSUB may be replaced with a glass substrate or a polymer resin substrate, such as polyimide. In this instance, thin-film transistors may be arranged on a glass substrate or a polymer resin substrate. The glass substrate may be a rigid substrate that is not bent, while the polymer resin substrate may be a flexible substrate that can be bent or curved.

The light-emitting element backplane EBP includes a plurality of conductive layers ML1 to ML8, a plurality of via electrodes VA1 to VA9, and a plurality of insulating layers INS1 to INS9. In addition, the light-emitting element backplane EBP includes the plurality of insulating layers INS1 to INS9 arranged between the first to eighth conductive layers ML1 to ML8.

The first to eighth conductive layers ML1 to ML8 may implement a circuit of a first sub-pixel SP1 shown in FIG. 4 by connecting a plurality of contact terminals CTE exposed from the semiconductor backplane SBP. For example, the first to sixth transistors T1 to T6 are only formed in the semiconductor backplane SBP, and the connection of the first to sixth transistors T1 to T6 and the first capacitor C1 and the second capacitor C2 are made through the first to eighth conductive layers ML1 to ML8. In addition, the connection between the drain region corresponding to the drain electrode of the fourth transistor T4, the source region corresponding to the source electrode of the fifth transistor T5, and a first electrode AND of the light-emitting element LE is also made through the first to eighth conductive layers ML1 to ML8.

The first insulating layer INS1 may be located on the semiconductor backplane SBP. Each of the first via electrodes VA1 may penetrate the first insulating layer INS1 and may be connected to the contact terminal CTE exposed from the semiconductor backplane SBP. Each of the first conductive layers ML1 may be located on the first insulating layer INS1 and may be connected to the first via electrodes VA1.

The second insulating layer INS2 may be located on the first insulating layer INS1 and the first conductive layers ML1. Each of the second via electrodes VA2 may penetrate through the second insulating layer INS2 to be connected to the exposed first metal layer ML1. Each of the second conductive layers ML2 may be located on the second insulating layer INS2 and may be connected to the second via electrodes VA2.

The third insulating layer INS3 may be located over the second insulating layer INS2 and the second conductive layers ML2. Each of the third via electrodes VA3 may penetrate through the third insulating layer INS3 to be connected to the exposed second conductive layer ML2. Each of the third conductive layers ML3 may be located on the third insulating layer INS3 and may be connected to the third via electrodes VA3.

The fourth insulating layer INS4 may be located over the third insulating layer INS3 and the third conductive layers ML3. Each of the fourth vias VA4 may penetrate through the fourth insulating layer INS4 to be connected to the exposed third conductive layer ML3. Each of the fourth conductive layers ML4 may be located on the fourth insulating layer INS4 and may be connected to the fourth via electrodes VA4.

The fifth insulating layer INS5 may be located over the fourth insulating layer INS4 and the fourth conductive layers ML4. Each of the fifth via electrodes VA5 may penetrate through the fifth insulating layer INS5 to be connected to the exposed fourth conductive layer ML4. Each of the fifth conductive layers ML5 may be located on the fifth insulating layer INS5 and may be connected to the fifth via electrodes VA5.

The sixth insulating layer INS6 may be located over the fifth insulating layer INS5 and the fifth conductive layers ML5. Each of the sixth via electrodes VA6 may penetrate through the sixth insulating layer INS6 to be connected to the exposed fifth conductive layer ML5. Each of the sixth conductive layers ML6 may be located on the sixth insulating layer INS6 and may be connected to the sixth via electrodes VA6.

The seventh insulating layer INS7 may be located over the sixth insulating layer INS6 and the sixth conductive layers ML6. Each of the seventh via electrodes VA7 may penetrate through the seventh insulating layer INS7 to be connected to the exposed sixth conductive layer ML6. Each of the seventh conductive layers ML7 may be located on the seventh insulating layer INS7 and may be connected to the seventh via electrodes VA7.

The eighth insulating layer INS8 may be located over the seventh insulating layer INS7 and the seventh conductive layers ML7. Each of the eighth via electrodes VA8 may penetrate through the eighth insulating layer INS8 to be connected to the exposed seventh conductive layer ML7. Each of the eighth conductive layers ML8 may be located on the eighth insulating layer INS8 and may be connected to the eighth via electrodes VA8.

The first to eighth conductive layers ML1 to ML8 and the first to eighth via electrodes VA1 to VA8 may be made of substantially the same material. The first to eighth conductive layers ML1 to ML8 and the first to eighth via electrodes VA1 to VA8 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. The first to eighth via electrodes VA1 to VA8 may be made of substantially the same material. The first to eighth insulating layers INS1 to INS8 may be formed as inorganic films, such as silicon oxide films, but embodiments of the present specification are not limited thereto.

The thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially all equal. For example, the thickness of the first conductive layer ML1 may be approximately 1,360 Å, the thickness of the second conductive layer ML2, the thickness of the third conductive layer ML3, the thickness of the fourth conductive layer ML4, the thickness of the fifth conductive layer ML5 and the thickness of the sixth conductive layer ML6 may be approximately 1,440 Å, and the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6 may be approximately 1,150 Å.

The thickness of the seventh conductive layer ML7 and the thickness of the eighth conductive layer ML8 may be greater than the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. The thickness of the seventh conductive layer ML7 and the thickness of the eighth conductive layer ML8 may be greater than the thickness of the seventh via electrode VA7 and the thickness of the eighth via electrode VA8. The thickness of the seventh via electrode VA7 and the thickness of the eighth via electrode VA8 may be greater than the thickness of the first via electrode VA1, the thickness of the second via electrode VA2, the thickness of the third via electrode VA3, and the thickness of the fourth via electrode VA4, the thickness of the fifth via electrode VA5, and the thickness of the sixth via electrode VA6. The thickness of the seventh conductive layer ML7 may be substantially equal to the thickness of the eighth conductive layer ML8. For example, the thickness of the seventh conductive layer ML7 and the thickness of the eighth conductive layer ML8 may be approximately 9,000 Å. The thickness of the seventh via electrode VA7 and the thickness of the eighth via electrode VA8 may be approximately 6,000 Å.

The ninth insulating layer INS9 may be located over the eighth insulating layer INS8 and the eighth conductive layer ML8. The ninth insulating layer INS9 may be formed as an inorganic film, such as a silicon oxide (SiOx) film, but the embodiments of the present disclosure are not limited thereto.

Each of the ninth via electrodes VA9 may penetrate through the ninth insulating layer INS9 to be connected to the exposed eighth conductive layer ML8. The ninth via electrodes VA9 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. The thickness of the ninth via electrode VA9 may be approximately 16,500 Å.

The display element layer EML may be located on the light-emitting element backplane EBP. The display element layer EML may include a plurality of connection electrodes ANC, a plurality of reflective electrodes RL, a planarization layer PNS, a plurality of pixel-defining layers PDL, a plurality of first electrodes AND, an emission unit EU, a second electrode CAT, and a plurality of separators SPR.

In addition, the display element layer EML may include a first emission area EA1, a second emission area EA2, and a third emission area EA3. In each of the first emission area EA1, the second emission area EA2, and the third emission area EA3, the first electrode AND, the emission unit EU, and the second electrode CAT may be sequentially stacked on one another. In each of the first emission area EA1, the second emission area EA2, and the third emission area EA3, a light-emitting element LE including a first electrode AND, an emission unit EU, and a second electrode CAT are arranged. Each of the first emission area EA1, the second emission area EA2, and the third emission area EA3 may be defined by the pixel-defining layer PDL.

A plurality of connection electrodes ANC may be arranged on the ninth insulating layer INS9. For example, the plurality of connection electrodes ANC may be arranged on the ninth insulating layer INS9 so as to be connected to a plurality of ninth via electrodes VA9, respectively. Each of the connection electrodes ANC may be made of titanium nitride (TiN) or a transparent conductive oxide. For example, the transparent conductive oxide may be, but is not limited to, indium tin oxide (ITO) or indium zinc oxide (IZO).

A plurality of reflective electrodes RL may be located on a plurality of connection electrodes ANC, respectively. For example, the reflective electrodes RL may be arranged between the connection electrodes ANC and optical auxiliary layers OAL, respectively. Each of the reflective electrodes RL may be made of one of copper (Cu), aluminium (Al), sliver (Ag), tungsten (W), molybdenum (Mo), chromium (Cr), gold (Au), titanium (Ti), nickel (Ni), or neodymium (Nd), or an alloy containing one of these. For example, each of the reflective electrodes RL may include aluminium (Al) or sliver (Ag). Among the reflective electrodes RL and the connection electrodes ANC, the connection electrodes ANC may have a larger area. For example, the area of the connection electrodes ANC may be larger than that of the reflective electrodes RL when viewed from the top so that the edges of the connection electrodes ANC surround the reflective electrodes RL (e.g., in plan view).

The optical auxiliary layers OAL may be located on the reflective electrodes RL, respectively. For example, the optical auxiliary layers OAL may be located on the upper surfaces of the reflective electrodes RL and the side surfaces of the reflective electrodes RL. The optical auxiliary layers OAL may be in contact (or direct contact) with the upper surfaces of the reflective electrodes RL and the side surfaces of the reflective electrodes RL. In addition, the optical auxiliary layers OAL may be located on the edges of the connection electrodes ANC. The optical auxiliary layers OAL may be in contact (or direct contact) with the edges of the upper surfaces of the connection electrodes ANC. The optical auxiliary layer OAL may surround the upper surfaces and the side surfaces of the reflective electrodes RL. In this instance, the optical auxiliary layers OAL may completely surround the reflective electrodes RL together with the connection electrodes ANC (e.g., in plan view). For example, in a cross-sectional view, the reflective electrodes RL may be completely surrounded by the optical auxiliary layers OAL and the connection electrodes ANC. The optical auxiliary layers OAL may have a thickness of approximately 100 Å or less. The optical auxiliary layers OAL may be made of an inorganic film, such as a silicon oxide (SiOx) film, but the embodiments of the present disclosure are not limited thereto.

Each of the light-emitting elements LE may include a first electrode AND, an emission unit EU, and a second electrode CAT.

The first electrode AND may be located on the optical auxiliary layer OAL. For example, the first electrode AND may be located on the upper surface of the optical auxiliary layer OAL, the side surfaces of the optical auxiliary layer OAL, the side surfaces of the connection electrode ANC, and the upper surface of the ninth insulating layer INS9. The first electrode AND may be in contact (or in direct contact) with the upper surface of the optical auxiliary layer OAL, the side surfaces of the optical auxiliary layer OAL, the side surfaces of the connection electrode ANC, and the upper surface of the ninth insulating layer INS9. As the side surfaces of the first electrode AND and the side surfaces of the connection electrode ANC are in contact with each other, the first electrode AND and the connection electrode ANC may be electrically connected to each other. The optical auxiliary layer OAL may be located between the first electrode AND and the reflective electrode RL. For example, the optical auxiliary layer OAL may be located between the side surfaces of the first electrode AND and the side surfaces of the reflective electrode RL. Accordingly, it is possible to reduce or prevent the likelihood of direct contact between the first electrode AND and the reflective electrode RL.

The thickness of the first electrode AND on the side surfaces of the optical auxiliary layer OAL may be different from the thickness of the first electrode AND on the upper surface of the optical auxiliary layer OAL. For example, the thickness of the first electrode AND on the side surfaces of the optical auxiliary layer OAL may be less than the thickness of the first electrode AND on the upper surface of the optical auxiliary layer OAL. For example, the thickness of the first electrode AND overlapping with the side surfaces of the reflective electrode RL may be less than the thickness of the first electrode AND overlapping with the upper surface of the reflective electrode RL.

The first electrode AND of each of the light-emitting elements LE may be connected to the drain region DA or the source region SA of the pixel transistor PTR through the connection electrode ANC, the first to ninth via electrodes VA1 to VA9, the first to eighth metal layers ML1 to ML8 and the contact terminal CTE.

The first electrode AND of each of the light-emitting elements LE may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the first electrode AND of each of the light-emitting elements LE may be titanium nitride (TiN).

The pixel-defining layer PDL may define the first emission areas EA1, the second emission areas EA2, and the third emission areas EA3. The pixel-defining layer PDL may be located partially on the first electrode AND of each of the light-emitting elements LE. The pixel-defining layer PDL may cover the edges of the first electrode AND of each of the light-emitting elements LE. The pixel-defining layer PDL may be in contact with (or in direct contact with) the first electrode AND. The pixel-defining layer PDL may be located on the first electrode AND. For example, the pixel-defining layer PDL may be located on the upper surface of the first electrode AND and the side surfaces of the first electrode AND. The pixel-defining layer PDL may be made of a material including silicon nitride (SiNx). Because the pixel-defining layer PDL may be made of a different material from the planarization layer PNS to be described later, the pixel-defining layer PDL may work as an etch-stop layer that defines the thickness (or height) of the planarization layer PNS when the planarization layer PNS is removed by chemical mechanical polishing (CMP).

A first emission area EA1 may be defined as an area in the first sub-pixel SP1 where the first electrode AND, the emission unit EU, and the second electrode CAT are sequentially stacked on one another to emit light. The second emission area EA2 may be defined as an area in the second sub-pixel SP2 where the first electrode AND, the emission unit EU, and the second electrode CAT are sequentially stacked on one another to emit light. The third emission area EA3 may be defined as an area in the third sub-pixel SP3 where the first electrode AND, the emission unit EU, and the second electrode CAT are sequentially stacked on one another to emit light.

The planarization layer PNS may be placed between the first electrodes AND of the sub-pixels SP1, SP2, and SP3 to eliminate the height differences between the sub-pixels SP1, SP2, and SP3. For example, the planarization layer PNS may be located between the pixel-defining layers PDL. The planarization layer PNS may be made of a material containing silicon oxide (SiOx). In other implementations, the planarization layer PNS may be eliminated. In this instance, the separators SPR may be arranged between adjacent sub-pixels SP1 to SP3.

The separators SPR may be arranged on the pixel-defining layer PDL and the planarization layer PNS. When viewed from the top, the separators SPR may have a closed curve shape surrounding each of the emission areas EA1, EA2, and EA3 as shown in FIGS. 5 and 6. Each of the separators SPR may be arranged on the pixel-defining layer PDL and the planarization layer PNS to surround each of the emission areas EA1, EA2, and EA3. The separators SPR may be features for cutting the emission units EU. To this end, according to one or more embodiments, each of the separators SPR may include a first bank BK1, a second bank BK2, and a third bank BK3 having different areas.

The first bank BK1 may be located on the pixel-defining layer PDL and the planarization layer PNS. The first bank BK1 may be made of the same material as the planarization layer PNS. For example, the first bank BK1 may be made of a material containing silicon oxide (SiOx). In this instance, the first bank BK1 and the planarization layer PNS may be formed integrally without any interface.

The second bank BK2 may be located on the first bank BK1. The second bank BK2 may be located on the second bank BK2 so that it overlaps with the first bank BK1. The area of the second bank BK2 may be smaller than the area of the first bank BK1. For example, when viewed from the top, the area of the second bank BK2 may be smaller than the area of the first bank BK1 so that the second bank BK2 may be surrounded by the edges of the first bank BK1. The etch rate of the second bank BK2 may be different from the etch rate of the first bank BK1. For example, the etch rate of the second bank BK2 may be greater than the etch rate of the first bank BK1. The second bank BK2 may be made of a material containing silicon nitride (SiNx). Alternatively, the second bank BK2 may be made of a material containing a metal. For example, the second bank may be made of a material containing at least one of titanium (Ti), tantalum (Ta), or molybdenum (Mo).

The third bank BK3 may be located on the second bank BK2. The third bank BK3 may be located on the second bank BK2 so that it overlaps with the second bank BK2. The area of the third bank BK3 may be larger than the area of the second bank BK2. For example, when viewed from the top, the area of the third bank BK3 may be larger than that of the second bank BK2 so that the third bank BK3 may surround the edges of the second bank BK2. Accordingly, as shown in FIG. 7, the third bank BK3 may include a tip TP that does not overlap with the second bank BK2. The etch rate of the second bank BK2 may be different from the etch rate of the third bank BK3. For example, the etch rate of the second bank BK2 may be greater than the etch rate of the third bank BK3. The third bank BK3 may be made of a material containing silicon oxide (SiOx).

The separator SPR including the first bank BK1, the second bank BK2, and the third bank BK3 may have a width at the center that is less than that of the upper and lower sides in the cross-sectional view.

According to one or more other embodiments, the separator SPR may include the first bank BK1, the second bank BK2, and the third bank BK3 made of the same material. In this instance, the first bank BK1, the second bank BK2, and the third bank BK3 may be formed integrally, and the ends of the first bank BK1, the second bank BK2, and the third bank BK3 may be aligned with one another. In this instance, the taper angle of the separator SPR including the first bank BK1, the second bank BK2, and the third bank BK3 may be an acute angle.

The emission units EU may be arranged on the first electrodes AND, the pixel-defining layers PDL and the separators SPR. For example, the emission unit EU may be arranged on the first bank BK1 and the third bank BK3 of the separator SPR. It should be noted that the emission unit EU may be disconnected on the separators SPR. For example, the emission unit EU may be cut between the first bank BK1 and the third bank BK3. When viewed from the top, the emission unit EU may be cut along the separator SPR. Accordingly, the emission unit EU may be divided into a portion in contact with the first electrode AND in the emission area, and a portion located on an area other than the emission area (e.g., on the third bank BK3 of the separator SPR). In other words, the emission unit EU may be cut along the separator SPR so that it is separated for each sub-pixel. Accordingly, the lateral leakage current between adjacent sub-pixels SP1, SP2, and SP3 can be suppressed. By suppressing the lateral leakage current, the color mixing between the adjacent sub-pixels SP1, SP2, and SP3 can be reduced or prevented, thereby improving the image quality of the display device 10.

The emission unit EU may include a first emission stack IL1, a charge generation layer CGL, and a second emission stack IL2 sequentially stacked on one another along the third direction DR3 between the first electrode AND and the second electrode CAT, as shown in FIG. 9. The charge generation layer CGL may be located between the first emission stack IL1 and the second emission stack IL2.

The first emission stack IL1 may include a hole injection layer HIL, a hole transport layer HTL1, a first emissive layer EML1, and an electron transport layer ETL1. The hole injection layer HIL may be located on the first electrode AND, the hole transport layer HTL1 may be located on the hole injection layer HIL, the first emissive layer EML1 may be located on the hole transport layer HTL1, and the electron transport layer ETL1 may be located on the first emissive layer EML1.

The charge generation layer CGL may be located on the first emission stack IL1. For example, the charge generation layer CGL may be located on the electron transport layer ETL1 of the first emission stack IL1.

The second emission stack IL2 may include a hole transport layer HTL2, a second emissive layer EML2, an electron transport layer ETL2, and an electron injection layer EIL. The second emissive layer EML2 may include a plurality of emissive layers for providing lights of different colors. For example, the second emissive layer EML2 may include a (2-1) emissive layer EML2-1 and a (2-2) emissive layer EML2-2, and the (2-1) emissive layer EML2-1 and the (2-2) emissive layer EML2-2 may provide light of different colors. The hole transport layer HTL2 may be located on the charge generation layer CGL, the (2-1) emissive layer EML2-1 may be located on the hole transport layer HTL2, the (2-2) emissive layer EML2-2 may be located on the (2-1) emissive layer EML2-1, the electron transport layer ETL2 may be located on the (2-2) emissive layer EML2-2, and the electron injection layer EIL may be located on the electron transport layer ETL2.

The first emissive layer EML1, the (2-1) emissive layer EML2-1, and the (2-2) emissive layer EML2-2 may provide light of different colors. For example, one of the first emissive layer EML1, the (2-1) emissive layer EML2-1, or the (2-2) emissive layer EML2-2 may provide light of a first color, another emissive layer may provide light of a second color, and the other emissive layer may provide light of a third color. One of the first color, the second color, and the third color may be red, another color may be green, and the other color may be blue. For example, the first emissive layer EML1 may provide blue light, the (2-1) emissive layer EML2-1 may provide red light, and the (2-2) emissive layer EML2-2 may provide green light.

At least one of the elements of the emission unit EU may be disconnected by the separator SPR. For example, the charge generation layer CGL of the emission unit EU may be disconnected by the separator SPR.

The second electrode CAT may be located on the emission unit EU. For example, the second electrode CAT may be placed on the electron injection layer EIL of the second emission stack IL2. The second electrode CAT may be placed on the electron injection layer EIL of the emission unit EU without being disconnected by the separator SPR. The second electrode CAT may be formed as a semi-transmissive conductive material, such as magnesium (Mg), silver (Ag), or an alloy of magnesium (Mg) and silver (Ag). In this instance, the light extraction efficiency can be increased by using microcavities in each of the first to third sub-pixels SP1, SP2, and SP3.

As shown in FIG. 8, the second electrode CAT may include a protruding electrode 555b protruding toward the semiconductor substrate SSUB. For example, the second electrode CAT may include a base electrode 555a, and a protruding electrode 555b protruding from the base electrode 555a toward the semiconductor substrate SSUB.

The base electrode 555a of the second electrode CAT may be located on the emission unit EU. For example, the base electrode 555a may be placed on the electron injection layer EIL of the emission unit EU.

The protruding electrode 555b of the second electrode CAT protrudes (or is extended) from the base electrode 555a toward the emission unit EU. For example, the protruding electrode 555b may protrude toward the emission unit EU in an area XEA where the upper surface of the pixel-defining layer PDL and the base electrode 555a overlap each other (hereinafter referred to as the auxiliary emission area XEA). The protruding electrode 555b may protrude toward the separator SPR in the auxiliary emission area XEA. A part of the emission unit EU may be depressed along the direction toward the separator SPR by the protruding electrode 555b. The end of the protruding electrode 555b may have a sharp shape. For example, the protruding electrode 555b may have a width that gradually decreases along the direction from the base electrode 555a toward the separator SPR. In other words, the protruding electrode 555b may have a triangular cross-section with a sharp end. As the protruding electrode 555b may protrude in a relatively sharp shape as described above, an electric field may be concentrated on the protruding electrode 555b. For example, a part of the electric field between the first electrode AND and the second electrode CAT may be concentrated on the protruding electrode 555b. In addition, as the protruding electrode 555b protrudes from the auxiliary emission area XEA toward the separator SPR (or the first electrode AND), the distance between the second electrode CAT and the hole injection layer HIL on the pixel-defining layer PDL may be reduced. In other words, a second distance d2 may be less than a first distance d1, where the distance between the second electrode CAT (e.g., the base electrode 555a) and the hole injection layer HIL on the first electrode AND in the first emission area EA1 is defined as the first distance d1, and the distance between the second electrode CAT (e.g., the protruding electrode 555b) and the hole injection layer HIL on the pixel-defining layer PDL in the auxiliary emission area XEA is defined as the second distance d2. The first distance d1 may refer to the distance between the second electrode CAT (e.g., the base electrode 555a) and the hole injection layer HIL on the first electrode AND in the third direction DR3, and the second distance d2 may refer to the distance between the second electrode CAT (e.g., the protruding electrode 555b) and the hole injection layer HIL on the pixel-defining layer PDL in the third direction DR3.

As described above, as the protruding electrode 555b may have the sharp shape, and the distance between the second electrode CAT and the hole injection layer HIL in the auxiliary emission area XEA is reduced by the protruding electrode 555b, the electric field may be concentrated and increased in the auxiliary emission area XEA. Accordingly, the amount of light emission from the emission unit EU in the auxiliary emission area XEA may increase, and, in turn, the aperture ratio of the first sub-pixel SP1 may increase. In other words, the aperture ratio of each of the sub-pixels SP1 to SP3 may be defined by the respective emission areas EA1 to EA3 defined by the openings of the pixel-defining layer PDL and the auxiliary emission area XEA adjacent to the emission areas EA1 to EA3, and thus the aperture ratio of each of the sub-pixels SP1 to SP3 can be improved. When viewed from the top, the auxiliary emission area XEA may surround the first emission area EA1. The auxiliary emission area XEA may be defined as the area between an end of the pixel-defining layer PDL (e.g., an inner wall of the pixel-defining layer PDL defining the first emission area EA1) and the separator SPR (e.g., an end of the first bank BK1).

The separator SPR may affect the degree of protrusion (or the degree of extension) of the protruding electrode 555b. To this end, the separator SPR may have a thickness TK of about 10 nm to about 100 nm. For example, the total thickness TK of a structure (e.g., the separator SPR) including the first bank BK1, the second bank BK2, and the third bank BK3 may be about 10 nm to about 100 nm. Herein, the thickness TK may refer to the size of the separator SPR in the third direction DR3.

The electron transport layer ETL of the emission unit EU may affect the degree of protrusion (or the degree of extension) of the protruding electrode 555b. In this regard, at least one of the electron transport layers ETL1 and ETL2 of the emission unit EU may include an organic molecule and a hydrogen bond bonded thereto. For example, at least one of the electron transport layer ETL1 of the first emission stack IL1 or the electron transport layer ETL2 of the second emission stack IL2 may include an organic molecule and hydrogen bonded to the organic molecule.

A capping layer CPL may be located on the second electrode CAT. The capping layer CPL may be eliminated.

An encapsulation layer TFE may be located on the capping layer CPL. The encapsulation layer TFE may include at least one inorganic film to reduce or prevent permeation of oxygen or moisture into the display element layer EML. For example, the encapsulating layer TFE may include a first inorganic encapsulation film, an organic encapsulation film, and a second inorganic encapsulation film sequentially stacked on one another in the third direction on the capping layer CPL. The first inorganic encapsulation film may be located on the capping layer CPL. The first inorganic encapsulation film may be made up of multiple films in which one or more inorganic films of silicon nitride (SiNx), silicon oxynitride (SiON), and a silicon oxide (SiOx) are alternately stacked on one another. The first inorganic encapsulation film may be formed via a chemical vapor deposition (CVD) process. The organic encapsulation film may be a monomer. Alternatively, the organic film may be an acryl resin, an epoxy resin, a phenolic resin, a polyamide resin, or a polyimide resin. The second inorganic encapsulation film may be located on the organic encapsulation film. The second inorganic encapsulation film may be made up of multiple films in which one or more inorganic films of silicon nitride (SiNx), silicon oxynitride (SiON), and a silicon oxide (SiOx) are alternately stacked on one another. The second inorganic encapsulation film may be formed via a chemical vapor deposition (CVD) process.

An organic film APL may be a layer to increase the interfacial adhesion between the encapsulation layer TFE and the optical layer OPL. The organic film APL may be placed between the encapsulation layer TFE and the optical layer OPL. The organic film APL may be an acryl resin, an epoxy resin, a phenolic resin, a polyamide resin, or a polyimide resin.

The optical layer OPL includes a plurality of color filters CF1, CF2, and CF3, a plurality of lenses LNS, and a filling layer FIL. The plurality of color filters CF1, CF2, and CF3 may include first to third color filters CF1, CF2, and CF3. The first to third color filters CF1, CF2, and CF3 may be arranged on the adhesive layer ADL.

The first color filter CF1 may be in line with the first emission area EA1 of the first sub-pixel SP1. The first color filter CF1 may transmit the first light among the light emitted from the emission unit EU of the first emission area EA1.

The second color filter CF2 may be in line with the second emission area EA2 of the second sub-pixel SP2. The second color filter CF2 may transmit the second light among the light emitted from the emission unit EU of the second emission area EA2.

The third color filter CF3 may be in line with the third emission area EA3 of the third sub-pixel SP3. The third color filter CF3 may transmit the third light among the light emitted from the emission unit EU of the third emission area EA3. The first to third light may be light of different colors. For example, the first light may be light of one of the first to third colors, the second light may be light of another color of the first to third colors, and the third light may be light of the other color of the first to third colors.

The lenses LNS may be arranged on the first color filter CF1, the second color filter CF2, and the third color filter CF3, respectively. Each of the lenses LNS may be a structure for increasing the ratio of light directed to the front side of the display device 10. Each of the lenses LNS may have a cross-sectional shape that is convex upward. It should be understood, however, that the embodiments of the present disclosure are not limited thereto.

The filling layer FIL may be located on a plurality of lenses LNS. The filling layer FIL may have a refractive index (e.g., predetermined refractive index) so that light travels in the third direction DR3 at the interface between the plurality of lenses LNS and the filling layer FIL. In addition, the filling layer FIL may be a planarization layer. The filling layer FIL may be an organic film, such as an acryl resin, an epoxy resin, a phenolic resin, a polyamide resin, and a polyimide resin.

The cover layer CVL may be located on the filling layer FIL. The cover layer CVL may be a glass substrate or a polymer resin, such as a resin. If the cover layer CVL is a glass substrate, it may be attached to the filling layer FIL. In this instance, the filling layer FIL may adhere the cover layer CVL. If the cover layer CVL is a glass substrate, it may work as an encapsulation substrate. If the cover layer CVL is a polymer resin, such as a resin, it may be applied directly on the filling layer FIL.

A polarizer POL may be located on a surface of the cover layer CVL. The polarizer POL may be a structure for reducing or preventing deterioration of visibility due to reflection of external light. The polarizer POL may include a linear polarizer and a retardation film. For example, the retardation film may be a λ/4 plate (quarter-wave plate), but the embodiments of the present disclosure are not limited thereto. If visibility is sufficiently improved by the first to third color filters CF1, CF2, and CF3 regardless of reflection of external light, the polarizer POL may be eliminated.

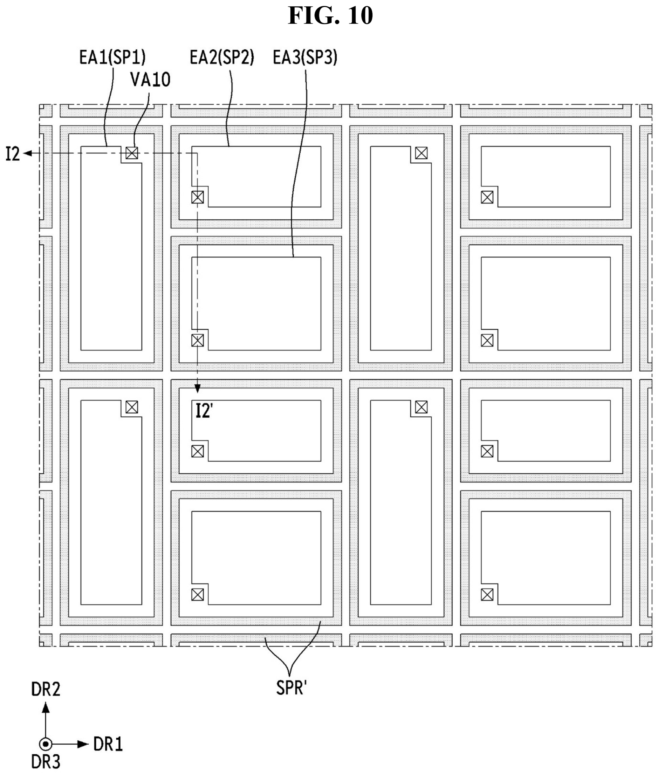

FIG. 10 is a view showing a layout of a display area according to one or more other embodiments. For example, FIG. 10 may be a view showing another example of a layout of the display area of FIG. 4 described above.

From the plan view shown in FIG. 10, a separator SPR' may have a closed curve shape surrounding emission areas EA1 to EA3 of sub-pixels SP1 to SP3, respectively. For example, as shown in FIG. 10, a plurality of separators SPR' may have a closed curve shape that surrounds each of the emission areas EA1 to EA3.

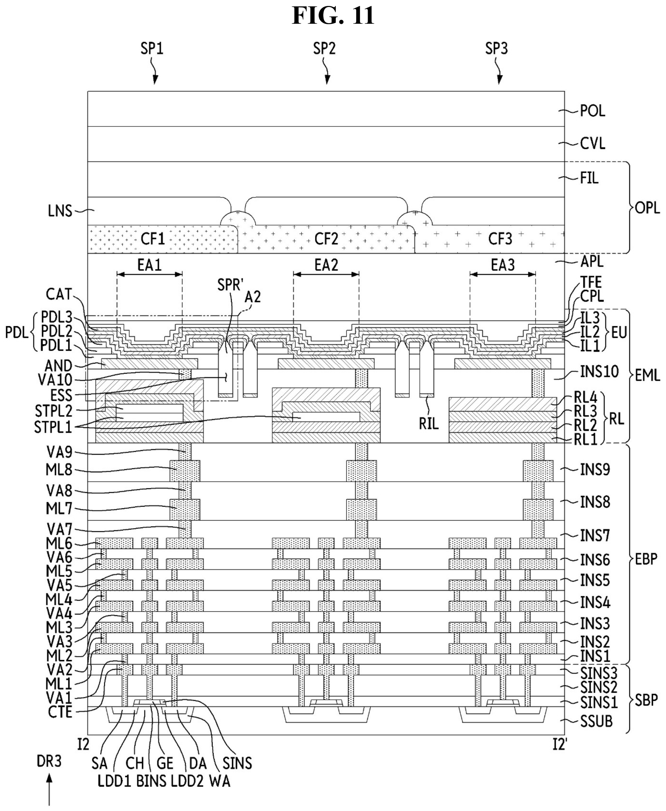

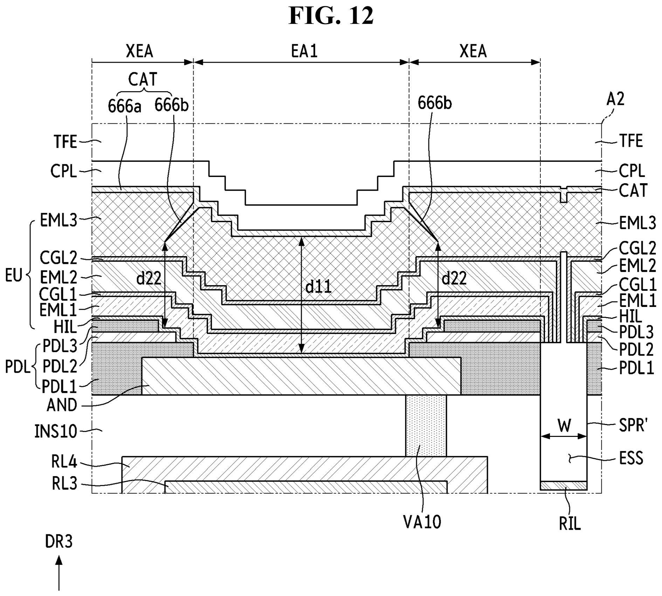

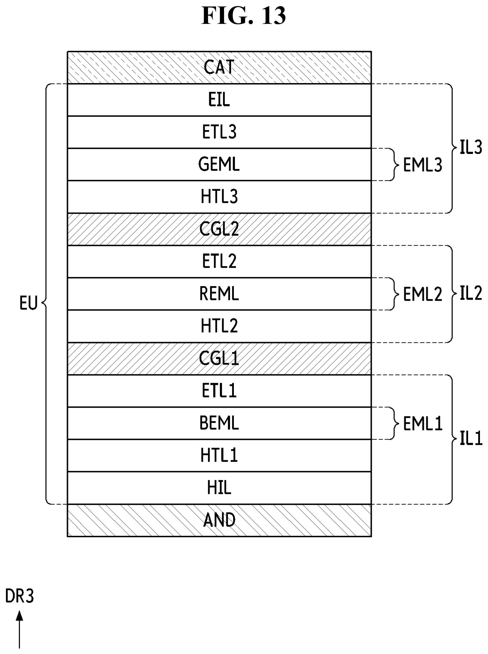

FIG. 11 is a cross-sectional view showing an example of the display panel, taken along line l2 - l2' of FIG. 10. FIG. 12 is a cross-sectional view showing area A2 of FIG. 11 in detail. FIG. 13 is a block diagram of the emission unit EU of FIG. 11.

Referring to FIG. 11, the display panel 100 includes a semiconductor backplane SBP, a light-emitting element backplane EBP, a display element layer EML, an encapsulation layer TFE, an optical layer OPL, a cover layer CVL, and a polarizer POL.

The semiconductor backplane SBP includes a semiconductor substrate SSUB including a plurality of pixel transistors PTR, a plurality of semiconductor insulating layers covering the plurality of pixel transistors PTR, and a plurality of contact terminals CTE that are electrically connected to the pixel transistors PTR, respectively. The plurality of pixel transistors PTR may be the first to sixth transistors T1 to T6 described above with reference to FIG. 4.

The semiconductor substrate SSUB may be a silicon substrate, a germanium substrate, or a silicon-germanium substrate. The semiconductor substrate SSUB may be a substrate doped with first-type impurities. A plurality of well areas WA may be located in the upper surface of the semiconductor substrate SSUB. The well areas WA may be doped with second-type impurities. The second-type impurities may be different from the first-type impurities. For example, when the first-type impurities are p-type impurities, the second-type impurities may be n-type impurities. Alternatively, when the first-type impurities are n-type impurities, the second-type impurities may be p-type impurities.

Each of the well areas WA includes a source region SA associated with a source electrode of a pixel transistor PTR, a drain region DA associated with a drain electrode thereof, and a channel region CH between the source region SA and the drain region DA.

A bottom insulating layer BINS may be located between the gate electrode GE and the well areas WA. Side insulating layers SINS may be located on the side surfaces of the gate electrode GE. The side insulating layers SINS may be located on the bottom insulating layer BINS.

Each of the source region SA and the drain region DA may be doped with the first-type impurities. The gate electrode GE of the pixel transistor PTR may overlap with the well area WA in the third direction DR3. The channel region CH may overlap with the gate electrode GE in the third direction DR3. The source region SA may be located on one side of the gate electrode GE, and the drain region DA may be located on the opposite side of the gate electrode GE.

Each of the plurality of well areas WA may further include a first low-concentration impurity region LDD1 located between the channel region CH and the source region SA, and a second low-concentration impurity region LDD2 located between the channel region CH and the drain region DA. The first low-concentration impurity region LDD1 may have a lower impurity concentration than the source region SA due to the bottom insulating layer BINS. The second low-concentration impurity region LDD2 may have a lower impurity concentration than the drain region DA due to the bottom insulating layer BINS. The distance between the source region SA and the drain region DA may be increased by the first low-concentration impurity region LDD1 and the second low-concentration impurity region LDD2. Therefore, the length of the channel region CH of each of the pixel transistors PTR can be increased, and thus it is possible to reduce or prevent punch-through and hot carrier phenomenon due to short channel.

A first semiconductor insulating layer SINS1 may be located on the semiconductor substrate SSUB. The first semiconductor insulating layer SINS1 may be formed of, but is not limited to, a silicon carbon nitride (SiCN) or a silicon oxide (SiOx)-based inorganic film.

A second semiconductor insulating layer SINS2 may be located on the first semiconductor insulating layer SINS1. The second semiconductor insulating layer SINS2 may be formed of a silicon oxide (SiOx)-based inorganic film, but the embodiments of the present disclosure are not limited thereto.

A plurality of contact terminals CTE may be located on the second semiconductor insulating layer SINS2. Each of the plurality of contact terminals CTE may be connected to one of the gate electrode GE, the source region SA, or the drain region DA of each of the pixel transistors PTR through a hole penetrating the first semiconductor insulating layer SINS1 and the second semiconductor insulating layer SINS2. The contact terminals CTE may be made of one of copper (Cu), aluminium (Al), tungsten (W), molybdenum (Mo), chromium (Cr), gold (Au), titanium (Ti), nickel (Ni), or neodymium (Nd), or an alloy containing one of these.

A third semiconductor insulating layer SINS3 may be located on the side surface of each of the contact terminals CTE. The upper surface of each of the contact terminals CTE may not be covered by the third semiconductor insulating layer SINS3 but may be exposed. The third semiconductor insulating layer SINS3 may be formed of a silicon oxide (SiOx)-based inorganic film, but the embodiments of the present disclosure are not limited thereto.

The semiconductor substrate SSUB may be replaced with a glass substrate or a polymer resin substrate, such as polyimide. In this instance, thin-film transistors may be arranged on a glass substrate or a polymer resin substrate. The glass substrate may be a rigid substrate that is not bent, while the polymer resin substrate may be a flexible substrate that can be bent or curved.

The light-emitting element backplane EBP includes a plurality of conductive layers ML1 to ML8, a plurality of via electrodes VA1 to VA9, and a plurality of insulating layers INS1 to INS10. In addition, the light-emitting element backplane EBP includes a plurality of insulating layers INS1 to INS9 arranged between the first to eighth conductive layers ML1 to ML8.

The first to eighth conductive layers ML1 to ML8 may implement a circuit of a first sub-pixel SP1 shown in FIG. 11 by connecting a plurality of contact terminals CTE exposed from the semiconductor backplane SBP. For example, the first to sixth transistors T1 to T6 are only formed in the semiconductor backplane SBP, and the connection of the first to sixth transistors T1 to T6 and the first capacitor CP1 and the second capacitor CP2 are made through the first to eighth conductive layers ML1 to ML8. In addition, the connection between the drain region corresponding to the drain electrode of the fourth transistor T4, the source region corresponding to the source electrode of the fifth transistor T5, and a first electrode AND of the light-emitting element LE is also made through the first to eighth conductive layers ML1 to ML8.

The first insulating layer INS1 may be located on the semiconductor backplane SBP. Each of the first via electrodes VA1 may penetrate the first insulating layer INS1 and may be connected to the contact terminal CTE exposed from the semiconductor backplane SBP. Each of the first conductive layers ML1 may be located on the first insulating layer INS1 and may be connected to the first via electrodes VA1.

The second insulating layer INS2 may be located on the first insulating layer INS1 and the first conductive layers ML1. Each of the second via electrodes VA2 may penetrate through the second insulating layer INS2 to be connected to the exposed first metal layer ML1. Each of the second conductive layers ML2 may be located on the second insulating layer INS2 and may be connected to the second via electrodes VA2.

The third insulating layer INS3 may be located over the second insulating layer INS2 and the second conductive layers ML2. Each of the third via electrodes VA3 may penetrate through the third insulating layer INS3 to be connected to the exposed second conductive layer ML2. Each of the third conductive layers ML3 may be located on the third insulating layer INS3 and may be connected to the third via electrodes VA3.

The fourth insulating layer INS4 may be located over the third insulating layer INS3 and the third conductive layers ML3. Each of the fourth vias VA4 may penetrate through the fourth insulating layer INS4 to be connected to the exposed third conductive layer ML3. Each of the fourth conductive layers ML4 may be located on the fourth insulating layer INS4 and may be connected to the fourth via electrodes VA4.

The fifth insulating layer INS5 may be located over the fourth insulating layer INS4 and the fourth conductive layers ML4. Each of the fifth via electrodes VA5 may penetrate through the fifth insulating layer INS5 to be connected to the exposed fourth conductive layer ML4. Each of the fifth conductive layers ML5 may be located on the fifth insulating layer INS5 and may be connected to the fifth via electrodes VA5.

The sixth insulating layer INS6 may be located over the fifth insulating layer INS5 and the fifth conductive layers ML5. Each of the sixth via electrodes VA6 may penetrate through the sixth insulating layer INS6 to be connected to the exposed fifth conductive layer ML5. Each of the sixth conductive layers ML6 may be located on the sixth insulating layer INS6 and may be connected to the sixth via electrodes VA6.

The seventh insulating layer INS7 may be located over the sixth insulating layer INS6 and the sixth conductive layers ML6. Each of the seventh via electrodes VA7 may penetrate through the seventh insulating layer INS7 to be connected to the exposed sixth conductive layer ML6. Each of the seventh conductive layers ML7 may be located on the seventh insulating layer INS7 and may be connected to the seventh via electrodes VA7.

The eighth insulating layer INS8 may be located over the seventh insulating layer INS7 and the seventh conductive layers ML7. Each of the eighth via electrodes VA8 may penetrate through the eighth insulating layer INS8 to be connected to the exposed seventh conductive layer ML7. Each of the eighth conductive layers ML8 may be located on the eighth insulating layer INS8 and may be connected to the eighth via electrodes VA8.

The first to eighth conductive layers ML1 to ML8 and the first to eighth via electrodes VA1 to VA8 may be made of substantially the same material. The first to eighth conductive layers ML1 to ML8 and the first to eighth via electrodes VA1 to VA8 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. The first to eighth via electrodes VA1 to VA8 may be made of substantially the same material. The first to eighth insulating layers INS1 to INS8 may be formed as inorganic films, such as silicon oxide films, but embodiments of the present specification are not limited thereto.

The thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5 and the thickness of the sixth conductive layer ML6 may be substantially all equal. For example, the thickness of the first conductive layer ML1 may be approximately 1,360 Å, the thickness of the second conductive layer ML2, the thickness of the third conductive layer ML3, the thickness of the fourth conductive layer ML4, the thickness of the fifth conductive layer ML5 and the thickness of the sixth conductive layer ML6 may be approximately 1,440 Å, and the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6 may be approximately 1,150 Å.

The thickness of the seventh conductive layer ML7 and the thickness of the eighth conductive layer ML8 may be greater than the thickness of the first conductive layer ML1, the thickness of the second conductive layer ML2, the thickness of the third conductive layer ML3, the thickness of the fourth conductive layer ML4, the thickness of the fifth conductive layer ML5 and the thickness of the sixth conductive layer ML6. The thickness of the seventh conductive layer ML7 and the thickness of the eighth conductive layer ML8 may be greater than the thickness of the seventh via electrode VA7 and the thickness of the eighth via electrode VA8. The thickness of the seventh via electrode VA7 and the thickness of the eighth via electrode VA8 may be greater than the thickness of the first via electrode VA1, the thickness of the second via electrode VA2, the thickness of the third via electrode VA3, and the thickness of the fourth via electrode VA4, the thickness of the fifth via electrode VA5, and the thickness of the sixth via electrode VA6. The thickness of the seventh conductive layer ML7 may be substantially equal to the thickness of the eighth conductive layer ML8. For example, the thickness of the seventh conductive layer ML7 and the thickness of the eighth conductive layer ML8 may be approximately 9,000 Å. The thickness of the seventh via electrode VA7 and the thickness of the eighth via electrode VA8 may be approximately 6,000 Å.

The ninth insulating layer INS9 may be located over the eighth insulating layer INS8 and the eighth conductive layer ML8. The ninth insulating layer INS9 may be formed as an inorganic film, such as a silicon oxide (SiOx) film, but the embodiments of the present disclosure are not limited thereto.

Each of the ninth via electrodes VA9 may penetrate through the ninth insulating layer INS9 to be connected to the exposed eighth conductive layer ML8. The ninth via electrodes VA9 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. The thickness of the ninth via electrode VA9 may be approximately 16,500 Å.

The display element layer EML may be located on the light-emitting element backplane EBP. The display element layer EML may include a reflective electrode RL, a tenth insulating layer INS10, a tenth via VA10, light-emitting elements LE each including a first electrode AND, an emission unit EU, and a second electrode CAT, a pixel-defining layer PDL, and a plurality of separators SPR'.

The reflective electrodes RL may be located on the ninth insulating layer INS9. The reflective electrodes RL may include at least one the reflective electrodes RL1, RL2, RL3, and RL4, a first step layer STPL1 and a second step layer STPL2. For example, although at least one reflective electrode RL1, RL2, RL3, and RL4 includes the first to fourth reflective electrodes RL1, RL2, RL3, and RL4 in the example shown in FIG. 11, the embodiments of the present disclosure are not limited thereto.

The first reflective electrodes RL1 may be located on the ninth insulating layer INS9 and may be connected to the ninth via electrode VA9. The first reflective electrodes RL1 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the first reflective electrodes RL1 may contain titanium nitride (TiN).

The second reflective electrodes RL2 may be located on the first reflective electrodes RL1. The second reflective electrodes RL2 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the second reflective electrodes RL2 may contain aluminium (Al).

The first step layer STPL1 may be arranged on the second reflective electrode RL2 in the second sub-pixel SP2 and the first sub-pixel SP1. In the third sub-pixel SP3, the first step layer STPL1 may not be arranged on the second reflective electrode RL2.

In the first sub-pixel SP1, the second step layer STPL2 may be arranged on the first step layer STPL1. In the third sub-pixel SP3, the second step layer STPL2 may not be arranged on the second reflective electrode RL2. In addition, the second step layer STPL2 may not be arranged on the first step layer STPL1 in the second sub-pixel SP2.

The thickness of the first step layer STPL1 may be determined based on the wavelength of light of a corresponding color emitted from the emission unit EU of the second sub-pixel SP2 and the distance from the emission unit EU to the fourth reflective electrode RL4 so that the light of the corresponding color can be suitably reflected. The thickness of the second step layer STPL2 may be determined based on the wavelength of light of a particular color emitted from the emission unit EU of the first sub-pixel SP1 and the distance from the emission unit EU to the fourth reflective electrode RL4 so that the light of the corresponding color can be suitably reflected.

The first step layer STPL1 and the second step layer STPL2 may be formed as, but is not limited to, inorganic films, such as a silicon carbon nitride (SiCN) film and a silicon oxide (SiOx) film.

In the third sub-pixel SP3, the third reflective electrode RL3 may be arranged on the second reflective electrode RL2. In the second sub-pixel SP2, the third reflective electrode RL3 may be arranged on the first step layer STPL1. In the first sub-pixel SP1, the third reflective electrode RL3 may be arranged on the second step layer STPL2. The third reflective electrodes RL3 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the third reflective electrodes RL3 may contain titanium nitride (TiN).

At least one of the first reflective electrode RL1, the second reflective electrode RL2, or the third reflective electrode RL3 may be eliminated.

The fourth reflective electrodes RL4 may be located on the third reflective electrodes RL3, respectively. The fourth reflective electrodes RL4 may be a layer that reflects light from the emission unit EU. The fourth reflective electrodes RL4 may include a metal with high reflectivity to be advantageous for light reflection. In addition, because the fourth reflective electrode RL4 is an electrode that substantially reflects light from the light-emitting elements LE, the thickness of the fourth reflective electrode RL4 may be greater than the thickness of the first reflective electrode RL1, the thickness of the second reflective electrode RL2 and the thickness of the third reflective electrode RL3. The fourth reflective electrodes RL4 may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the fourth reflective electrodes RL4 may include aluminium (Al) or titanium (Ti).

The tenth interlayer dielectric layer INS10 may be located on the ninth interlayer dielectric layer INS9 and the fourth reflective electrodes RL4. The tenth interlayer dielectric layer INS10 may be an optical auxiliary layer through which light emitted from the light-emitting elements LE and reflected by the reflective electrode RL passes. The tenth insulating layer INS10 may be made of an inorganic film, such as a silicon oxide (SiOx) film, but the embodiments of the present disclosure are not limited thereto.

Each of the tenth via electrodes VA10 may penetrate through the tenth insulating layer INS10 to be connected to the exposed fourth reflective electrode RL4. The ten via electrodes VA10 may be made of one of copper (Cu), aluminium (Al), tungsten (W), molybdenum (Mo), chromium (Cr), gold (Au), titanium (Ti), nickel (Ni), or neodymium (Nd), or an alloy containing one of these.

To match the resonance distance of light emitted from light-emitting elements LE in at least one of the first sub-pixel SP1, the second sub-pixel SP2, or the third sub-pixel SP3, the thickness of the tenth via electrode VA10 may vary in the first sub-pixel SP1, the second sub-pixel SP2, and the third sub-pixel SP3. For example, the thickness of the tenth via electrode VA10 in the first sub-pixel SP1 may be less than the thickness of the tenth via electrode VA10 in each of the third sub-pixel SP3 and the second sub-pixel SP2. In addition, the thickness of the tenth via electrode VA10 in the second sub-pixel PX2 may be less than the thickness of the tenth via electrode VA10 in the third sub-pixel PX3. For example, the distances between the emission unit EU and the reflective electrode RL in the first sub-pixel SP1, the second sub-pixel SP2, and the third sub-pixel SP3 may be different from one another.

To sum up, to adjust the distance between the emission unit EU and the reflective electrode RL according to the main wavelength of light emitted from the first sub-pixel SP1, the second sub-pixel SP2, and the third sub-pixel SP3, it may be determined whether to place the first and second step layers STPL1 and STPL2 in the first sub-pixel SP1, the second sub-pixel SP2, and the third sub-pixel SP3, as well as the thickness of each of the first and second step layers STPL1 and STPL2.

The first electrode AND of each of the light-emitting elements LE may be located on the tenth insulating layer INS10 and may be connected to the tenth via electrode VA10. The first electrode AND of each of the light-emitting elements LE may be connected to the drain region DA or the source region SA of the pixel transistor PTR through the tenth via electrode VA10, the first to fourth reflective electrodes RL1 to RL4, the first to ninth via electrodes VA1 to VA9, the first to eighth conductive layers ML1 to ML8 and the contact terminals CTE. The first electrode AND of each of the light-emitting elements LE may be made of one of copper (Cu), aluminium (Al), tungsten (W), molybdenum (Mo), chromium (Cr), gold (Au), titanium (Ti), nickel (Ni), or neodymium (Nd), or an alloy containing one of these. For example, the first electrode AND of each of the light-emitting elements LE may be titanium nitride (TiN).

The pixel-defining layer PDL may be located partially on the first electrode AND of each of the light-emitting elements LE. The pixel-defining layer PDL may cover the edge of the first electrode AND of each of the light-emitting elements LE. The pixel-defining layer PDL serves to partition the first emission areas EA1, the second emission areas EA2, and the third emission areas EA3.

A first emission area EA1 may be defined as an area in the first sub-pixel SP1 where the first electrode AND, the emission stack IL, and the second electrode CAT are sequentially stacked on one another to emit light. A second emission area EA2 may be defined as an area in the second sub-pixel SP2 where the first electrode AND, the emission stack IL, and the second electrode CAT are sequentially stacked on one another to emit light. A third emission area EA3 may be defined as an area in the third sub-pixel SP3 where the first electrode AND, the emission stack IL, and the second electrode CAT are sequentially stacked on one another to emit light.

The pixel-defining layer PDL may include first to third pixel-defining layers PDL1, PDL2, and PDL3. The first pixel-defining layer PDL1 may be located on the edge of the first electrode AND of each of the light-emitting elements LE, the second pixel-defining layer PDL2 may be located on the first pixel-defining layer PDL1, and the third pixel-defining layer PDL3 may be located on the second pixel-defining layer PDL2. The first pixel-defining layer PDL1, the second pixel-defining layer PDL2, and the third pixel-defining layer PDL3 may be formed as an inorganic film, such as a silicon oxide (SiOx) film, but the embodiments of the present disclosure are not limited thereto. The thickness of the first pixel-defining layer PDL1, the second pixel-defining layer PDL2, and the third pixel-defining layer PDL3 may each be approximately 500 Å.

When the first pixel-defining layer PDL1, the second pixel-defining layer PDL2, and the third pixel-defining layer PDL3 are formed as a single pixel-defining layer, the height of the single pixel-defining layer increases, and thus a first inorganic encapsulation film of the encapsulation layer TFE may be broken due to step coverage. Herein, the step coverage refers to a ratio of a thin film applied on an inclined portion to the thin film applied on a flat portion. The lower the step coverage is, the more likely it is that the thin film would break at the inclined portion.

Therefore, to reduce or prevent the likelihood of the first inorganic encapsulation film of the encapsulation layer TFE breaking due to step coverage, the first pixel-defining layer PDL1, the second pixel-defining layer PDL2, and the third pixel-defining layer PDL3 may have a cross-sectional structure in the form of stairs. For example, the width of the first pixel-defining layer PDL1 may be greater than the width of the second pixel-defining layer PDL2 and the width of the third pixel-defining layer PDL3, the width of the second pixel-defining layer PDL2 may be greater than the width of the third pixel-defining layer PDL3. The width of the first pixel-defining layer PDL1 refers to the horizontal length of the first pixel-defining layer PDL1 defined by the first direction DR1 and the second direction DR2.

Each of the plurality of separators SPR' may penetrate the first pixel-defining layer PDL1, the second pixel-defining layer PDL2, and the third pixel-defining layer PDL3. In addition, a part of the tenth insulating layer INS10 may be dug in each of the plurality of separators SPR'. For example, the separator SPR of FIG. 7 has the shape that protrudes toward the emission unit EU on the pixel-defining layer PDL and the planarization layer PNS, while the separator SPR' of FIG. 11 may have a shape of a trench including a hole penetrating the first to third pixel-defining layers PDL1 to PDL3 toward the semiconductor substrate SSUB on the third pixel-defining layer PDL3 and a groove formed in the tenth insulating layer INS10 under the first pixel-defining layer PDL1.

The emission unit EU may include a first emission stack IL1, a first charge generation layer CGL1, a second emission stack IL2, a second charge generation layer CGL2, and a third emission stack IL3 sequentially stacked on one another along the third direction DR3 between the first electrode AND and the second electrode CAT, as shown in FIG. 13. The first charge generation layer CGL1 may be located between the first emission stack IL1 and the second emission stack IL2, and the second charge generation layer CGL2 may be located between the second emission stack IL2 and the third emission stack IL3.

The first emission stack IL1 may include a hole injection layer HIL, a hole transport layer HTL1, a first emissive layer EML1, and an electron transport layer ETL1. The hole injection layer HIL may be located on the first electrode AND, the hole transport layer HTL1 may be located on the hole injection layer HIL, the first emissive layer EML1 may be located on the hole transport layer HTL1, and the electron transport layer ETL1 may be located on the first emissive layer EML1.

The first charge generation layer CGL1 may be arranged on the first emission stack IL1. For example, the first charge generation layer CGL1 may be arranged on the electron transport layer ETL1 of the first emission stack IL1.

The second emission stack IL2 may include a hole transport layer HTL2, a second emissive layer EML2, and an electron transport layer ETL2. The hole transport layer HTL2 may be located on the first charge generation layer CGL1, the second emissive layer EML2 may be located on the hole transport layer HTL2, and the electron transport layer ETL2 may be located on the second emissive layer EML2.

The second charge generation layer CGL2 may be arranged on the second emission stack IL2. For example, the second charge generation layer CGL2 may be arranged on the electron transport layer ETL2 of the second emission stack IL2.

The third emission stack IL3 may include a hole transport layer HTL3, a third emissive layer EML3, an electron transport layer ETL3, and an electron injection layer EIL. The hole transport layer HTL3 may be located on the second charge generation layer CGL2, the third emissive layer EML3 may be located on the hole transport layer HTL3, the electron transport layer ETL3 may be located on the third emissive layer EML3, and the electron injection layer EIL may be located on the electron transport layer ETL3.

The first emissive layer EML1, the second emissive layer EML2, and the third emissive layer EML3 may provide light of different respective colors. For example, one of the first emissive layer EML1, the second emissive layer EML2, or the third emissive layer EML3 may provide light of a first color, another emissive layer may provide light of a second color, and the other emissive layer may provide light of a third color. One of the first color, the second color, and the third color may be red, another color may be green, and the other color may be blue. For example, the first emissive layer EML1 may provide blue light, the second emissive layer EML2 may provide red light, and the third emissive layer EML3 may provide green light.

The first emission layer IL1 may be located on the first electrodes AND and the pixel-defining layer PDL. A residual stack RIL made of the same material as the first emission stack IL1 may be located on the bottom surface in each of the separators SPR'. Due to the separators SPR', the first emission stack IL1 may be disconnected between the adjacent sub-pixels SP1, SP2, and SP3. The second emission stack IL2 may be located on the first emission stack IL1. Due to the separators SPR', the second emission stack IL2 may be disconnected between the adjacent sub-pixels SP1, SP2, and SP3. A cavity ESS or empty space may be located between the residual stack RIL and the second emission stack IL2 in each of the separators SPR'. The third emission stack IL3 may be located on the second emission stack IL2. The third emission stack IL3 may not be disconnected by the separators SPR' and may cover the second emission stack IL2 in each of the separators SPR'. For example, each of the plurality of separators SPR' may be a structure for disconnecting the first emission stack IL1, the first charge generation layer CGL1, the second emission stack IL2, and the second charge generation layer CGL2 of the display element layer EML between adjacent sub-pixels SP1, SP2, and SP3. For example, when viewed from the top, the first emission stack IL1, the first charge generation layer CGL1, the second emission stack IL2, and the second charge generation layer CGL2 may be cut along the separators SPR'.

The second electrode CAT may be located on the emission unit EU. For example, the second electrode CAT may be placed on the electron injection layer EIL of the third emission stack IL3. The second electrode CAT may be placed on the electron injection layer EIL of the emission unit EU without being disconnected by the separator SPR'. The second electrode CAT may be formed as a semi-transmissive conductive material, such as magnesium (Mg), silver (Ag), or an alloy of magnesium (Mg) and silver (Ag). In this instance, the light extraction efficiency can be increased by using microcavities in each of the first to third sub-pixels SP1, SP2, and SP3.

As shown in FIG. 12, the second electrode CAT may include a protruding electrode 666b protruding toward the semiconductor substrate SSUB. For example, the second electrode CAT may include a base electrode 666a, and a protruding electrode 666b protruding from the base electrode 666a toward the semiconductor substrate SSUB.

The base electrode 666a of the second electrode CAT may be located on the emission unit EU. For example, the base electrode 666a may be placed on the electron injection layer EIL of the emission unit EU.

The protruding electrode 666b of the second electrode CAT protrudes (or is extended) from the base electrode 666a toward the emission unit EU. For example, the protruding electrode 666b may protrude toward the emission unit EU in an area where the upper surface of the pixel-defining layer PDL and the base electrode 666a overlap each other (hereinafter referred to as the auxiliary emission area XEA). The protruding electrode 666b may protrude toward the separator SPR' in the auxiliary emission area XEA. A part of the emission unit EU may be depressed along the direction toward the separator SPR' by the protruding electrode 666b. The end of the protruding electrode 666b may have a sharp shape. For example, the protruding electrode 666b may have a width that gradually decreases along the direction from the base electrode 666a toward the separator SPR'. In other words, the protruding electrode 666b may have a triangular cross-section with a sharp end. As the protruding electrode 666b protrudes in a sharp shape as described above, an electric field may be concentrated on the protruding electrode 666b. For example, a part of the electric field between the first electrode AND and the second electrode CAT may be concentrated on the protruding electrode 666b. In addition, as the protruding electrode 666b protrudes from the auxiliary emission area XEA toward the separator SPR' (or the first electrode AND), the distance between the second electrode CAT and the hole injection layer HIL on the pixel-defining layer PDL may be reduced. In other words, a second distance d22 may be less than a first distance d11, where the distance between the second electrode CAT (e.g., the base electrode 666a) and the hole injection layer HIL on the first electrode AND in the first emission area EA1 is defined as the first distance d11, and the distance between the second electrode CAT (e.g., the protruding electrode 666b) and the hole injection layer HIL on the pixel-defining layer PDL in the auxiliary emission area XEA is defined as the second distance d22. The first distance d11 may refer to the distance between the second electrode CAT (e.g., the base electrode 666a) and the hole injection layer HIL on the first electrode AND in the third direction DR3, and the second distance d22 may refer to the distance between the second electrode CAT (e.g., the protruding electrode 666b) and the hole injection layer HIL on the pixel-defining layer PDL in the third direction DR3.

As described above, as the protruding electrode 666b may have the sharp shape, and the distance between the second electrode CAT and the hole injection layer HIL in the auxiliary emission area XEA is reduced by the protruding electrode 666b, the electric field may be concentrated and increased in the auxiliary emission area XEA. Accordingly, the amount of light emitted from the emission unit EU in the auxiliary emission area XEA may increase, and, in turn, the aperture ratio of each of the sub-pixels SP1 to SP3 may increase. In other words, the aperture ratio of each of the sub-pixels SP1 to SP3 may be defined by the respective emission areas EA1 to EA3 defined by the openings of the pixel-defining layer PDL and the auxiliary emission area XEA adjacent to the emission areas EA1 to EA3, and thus the aperture ratio of each of the sub-pixels SP1 to SP3 can be improved. When viewed from the top, the auxiliary emission area XEA may surround the emission areas EA1 to EA3. The auxiliary emission area XEA may be defined as the area between an end of the pixel-defining layer PDL (e.g., an inner wall of the first pixel-defining layer PDL1 defining the first emission area EA1) and the separator SPR' (e.g., an inner wall of the pixel-defining layer PDL1 to PDL3 defining the separator SPR').

The separator SPR' may affect the degree of protrusion (or the degree of extension) of the protruding electrode 666b. To this end, the separator SPR' in the trench shape may have a width W of about 80 nm to about 200 nm. For example, the width W of the hole penetrating the first pixel-defining layer PDL1, the second pixel-defining layer PDL2, and the third pixel-defining layer PDL3 may range from about 80 nm to about 200 nm. Herein, the thickness may refer to the size of the separator SPR' in the third direction DR3.

The electron transport layer ETL of the emission unit EU may affect the degree of protrusion (or the degree of extension) of the protruding electrode 666b. To this end, according to one or more embodiments, at least one of the electron transport layers ETL1 to ETL3 of the emission unit EU may include an organic molecule and a hydrogen bond bonded thereto. For example, at least one of the electron transport layer ETL1 of the first emission stack IL1, the electron transport layer ETL2 of the second emission stack IL2, or the electron transport layer ETL3 of the third emission stack IL3 may include an organic molecule and hydrogen bonded to the organic molecule.

The capping layer CPL, the encapsulation layer TFE, the organic film APL, the optical layer OPL, the color filters CF1, CF2, and CF3, the plurality of lenses LNS, the filling layer FIL, the cover layer CVL, and the polarizing plate POL of FIGS. 11 and 12 are identical to the capping layer CPL, the encapsulation layer TFE, the organic film APL, the optical layer OPL, the color filters CF1, CF2, and CF3, the plurality of lenses LNS, the filling layer FIL, the cover layer CVL, and the polarizing plate POL of FIGS. 7 and 8. Therefore, redundant descriptions will be omitted.

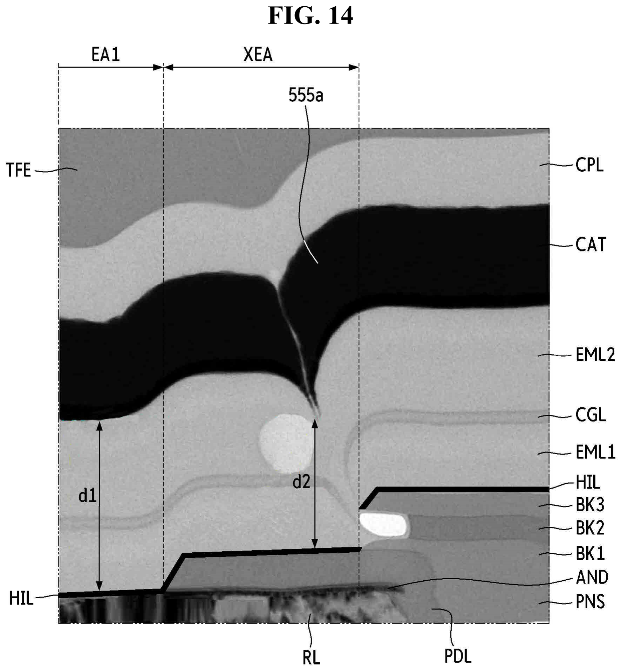

FIG. 14 is an image of a cross section of a display device according to one or more embodiments.

As shown in FIG. 14, the second distance d2 between the second electrode CAT (e.g., the protruding electrode 555b) and the hole injection layer HIL on the pixel-defining layer PDL in the auxiliary emission area XEA may be less than the first distance d1 between the second electrode CAT (e.g., the base electrode 555a) and the hole injection layer HIL on the first electrode AND in the first emission area EA1.

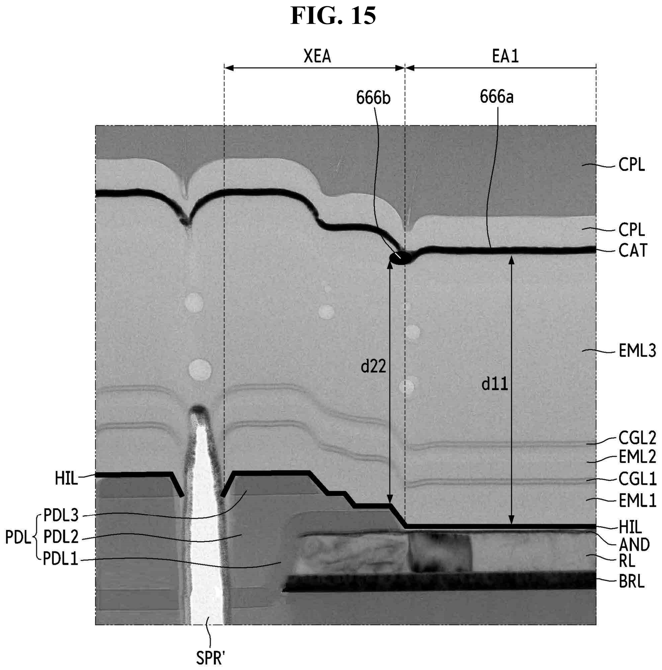

FIG. 15 is an image of a cross section of a display device according to one or more embodiments.

As shown in FIG. 15, the second distance d22 between the second electrode CAT (e.g., the protruding electrode 666b) and the hole injection layer HIL on the pixel-defining layer PDL in the auxiliary emission area XEA may be less than the first distance d11 between the second electrode CAT (e.g., the base electrode 666a) and the hole injection layer HIL on the first electrode AND in the first emission area EA1.

The display device 10 may be applied to a variety of electronic devices. An electronic device according to one or more embodiments includes the display device 10 described above, and may further include a module or device having additional features in addition to the display device 10.

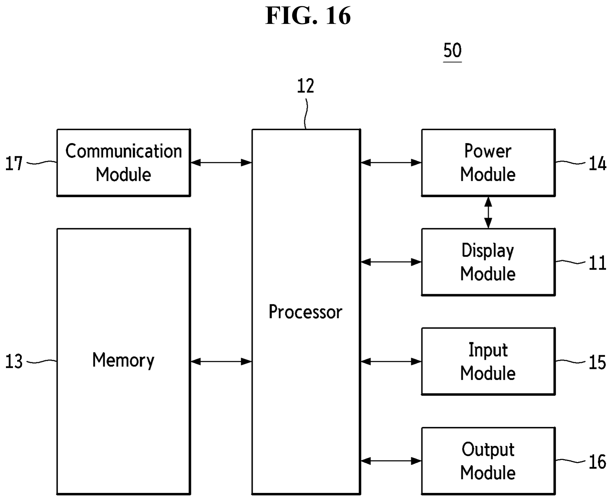

FIG. 16 is a block diagram of an electronic device according to one or more embodiments of the present disclosure. Referring to FIG. 16, an electronic device 50 according to one or more embodiments of the present disclosure may include a display module 11, a processor 12, a memory 13, and a power module 14. The electronic device 50 may further include an input module 15, a non-image output module 16, and/or a communication module 17.

The electronic device 50 may output various information in the form of images through the display module 11. When the processor 12 executes an application stored in the memory 13, image information provided by the application may be provided to the user through the display module 11. The power module 14 may include a power supply module, such as a power adapter and a battery device, and a power conversion module that converts the power supplied by the power supply module to generate power required for the operation of the electronic device 50. The input module 15 may provide input information to the processor 12 and/or the display module 11. The non-image output module 16 may receive information other than images from the processor 12, such as sound, haptic, and light, and may provide it to the user. The communication module 17 is responsible for transmitting and receiving information between the electronic device 50 and an external device, and may include a receiving unit and a transmitting unit.

At least one of the elements of the electronic device 50 described above may be included in the display devices according to the embodiments described above. In addition, some of the individual modules functioning as a single module may be included in the display device while some others may be provided separately from the display device. For example, the display device may include the display module 11, and the processor 12, the memory 13, and the power module 14 may be implemented as other devices inside the electronic device 50 instead of the display device.

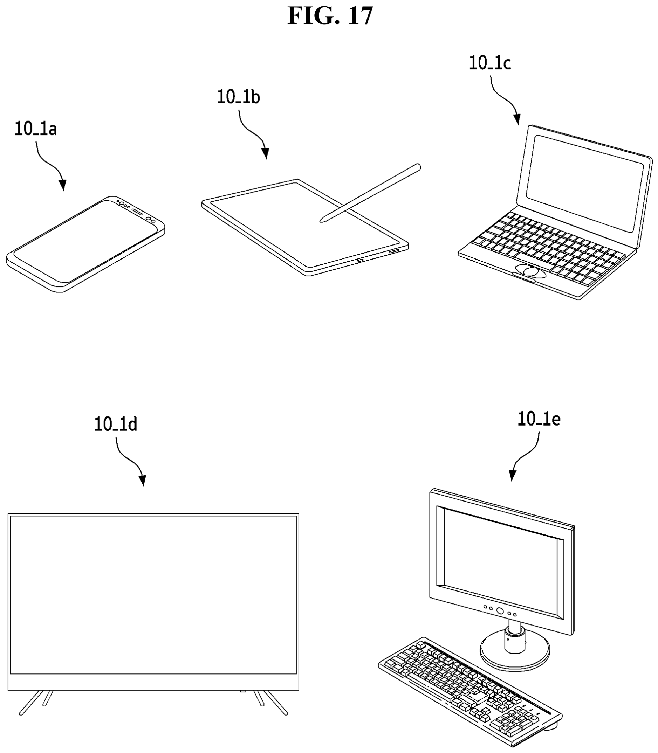

FIGS. 17, 18, and 19 are views showing electronic devices according to a variety of embodiments of the present disclosure. FIGS. 17 to 19 show examples of a variety of electronic devices employing the display devices 10 according to the embodiments.

FIG. 17 shows a smartphone 10_1a, a tablet PC 10_1b, a laptop computer 10_1c, a TV 10_1d, and a desktop monitor 10_1e as examples of the electronic devices.

The smartphone 10_1a may include an input module, such as a touch sensor and a communication module in addition to a display module 11. The smartphone 10_1a may process information received through the communication module or other input modules and display the information through the display module of the display device.

The tablet PCs 10_1b, the laptop computer 10_1c, the TV 10_1d and the desktop monitor 10_1e may include display modules and input modules similar to the smartphone 10_1a, and may further include communication modules as desired.

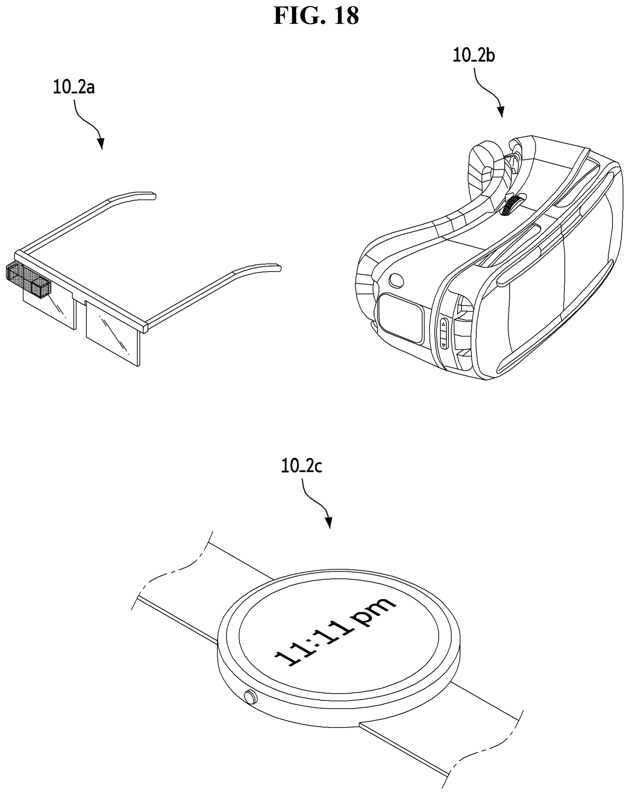

FIG. 18 shows examples of a wearable electronic device employing an electronic device including a display module. The wearable electronic devices may be smart glasses 10_2a, a head-mounted display 10_2b, a smart watch 10_2c, etc.

The smart glasses 10_2a and the head-mounted display 10_2b may include a display module that outputs display images, and a reflector that reflects the output display images and provides it to the user's eyes, thereby providing the user with images of virtual reality or augmented reality on the screen.

The smart watch 10_2c includes a biometric sensor as an input device, and may provide the user with biometric information recognized by the biometric sensor through the display module.

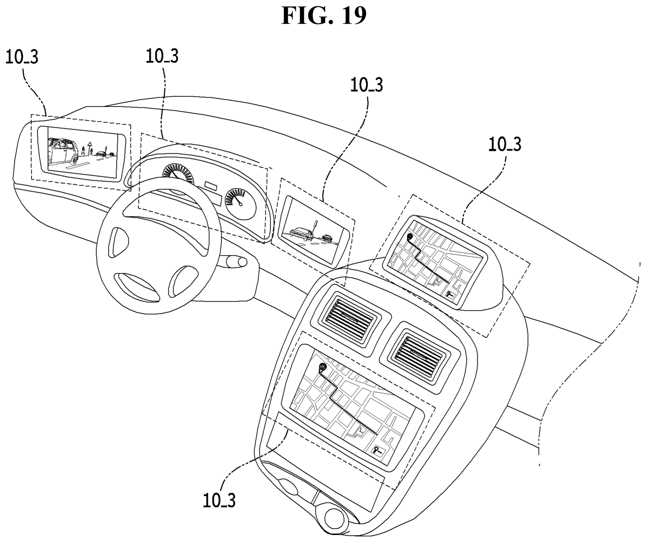

FIG. 19 shows an example of an electronic device including a display module applied to a vehicle. For example, an electronic device 10_3 may be applied to the instrument cluster, the center fascia, etc., of a vehicle, or may be applied to a center information display (CID) located at the dashboard of a vehicle, or may be used as a room mirror display on the behalf of the side mirrors of a vehicle.

In concluding the detailed description, those skilled in the art will appreciate that many variations and modifications can be made to the embodiments without substantially departing from the aspects of the present disclosure. Therefore, the disclosed embodiments of the disclosure are used in a generic and descriptive sense only and not for purposes of limitation.

## Claims

1. A display device (10) comprising:
a substrate (SSUB);
a first electrode (AND) above the substrate (SSUB);
a pixel-defining layer (PDL) above the first electrode (AND) and defining an emission area (EA1, EA2, EA3) in which the first electrode (AND) is exposed;
a separator (SPR) above the pixel-defining layer (PDL);
an emission unit (EU) above the first electrode (AND), the pixel-defining layer (PDL), and the separator (SPR); and
a second electrode (CAT) above the emission unit (EU) and comprising:
a base electrode (555a) above the emission unit (EU); and
a protruding electrode (555b) protruding from the base electrode (555a) toward the emission unit (EU).

2. The display device (10) of claim 1, wherein the emission unit (EU) has a depressed shape by the protruding electrode (555b).

3. The display device (10) of claim 1 or claim 2, wherein the protruding electrode (555b) protrudes toward the separator (SPR) overlapping with the emission unit (EU).

4. The display device (10) of claim 3, wherein the protruding electrode (555b) has a width that gradually decreases in a direction from the base electrode (555a) toward the separator (SPR).

5. The display device (10) of any one of claims 1 to 4, wherein the protruding electrode (555b) has a triangular cross-section.

6. The display device (10) of any one of claims 1 to 5, wherein the protruding electrode (555b) has a sharp end protruding toward the emission unit (EU).

7. The display device (10) of any one of claims 1 to 6, wherein the protruding electrode (555b) protrudes toward the emission unit (EU) in an auxiliary emission area (XEA) where the pixel-defining layer (PDL) and the base electrode (555a) overlap each other, optionally wherein the auxiliary emission area (XEA) surrounds the emission area (EA1, EA2, EA3) in plan view.

8. The display device (10) of claim 7, wherein the emission unit (EU) comprises a hole injection layer (HIL) above the first electrode (AND) and the pixel-defining layer (PDL), and
wherein a distance (d2) between the protruding electrode (555b) and the hole injection layer (HIL) above the pixel-defining layer (PDL) in the auxiliary emission area (XEA) is less than a distance (d1) between the base electrode (555a) and the hole injection layer (HIL) above the first electrode (AND) in the emission area (EA1, EA2, EA3).

9. The display device (10) of any one of claims 1 to 8, wherein the separator (SPR) has a thickness (TK) of about 10 nm to about 100 nm, and comprises:
a first bank (BK1) above the pixel-defining layer (PDL);
a second bank (BK2) above the first bank (BK1); and
a third bank (BK3) above the second bank (BK2) and having a width that is greater than that of the second bank (BK2), and
wherein a sum of thicknesses of the first bank (BK1), the second bank (BK2), and the third bank (BK3) ranges from about 10 nm to about 100 nm.

10. The display device (10) of any one of claims 1 to 9, wherein the emission unit (EU) comprises an electron transport layer (ETL1, ETL2) comprising:
an organic molecule; and
hydrogen bonded to the organic molecule.

11. A display device (10) comprising:
a substrate (SSUB);
a first electrode (AND) above the substrate (SSUB);
a pixel-defining layer (PDL) above the first electrode (AND) and defining an emission area (EA1, EA2, EA3) in which the first electrode (AND) is exposed;
a separator (SPR') penetrating the pixel-defining layer (PDL);
an emission unit (EU) above the first electrode (AND), the pixel-defining layer (PDL), and the separator (SPR'); and
a second electrode (CAT) above the emission unit (EU) and comprising:
a base electrode (666a) above the emission unit (EU); and
a protruding electrode (666b) protruding from the base electrode (666a) toward the emission unit (EU).

12. The display device (10) of claim 11, wherein:
(i) the protruding electrode (666b) protrudes toward the emission unit (EU) in an auxiliary emission area (XEA) where the pixel-defining layer (PDL) and the base electrode (666a) overlap each other; and/or
(ii) the emission unit (EU) has a depressed shape by the protruding electrode (666b); and/or
(iii) the protruding electrode (666b) protrudes toward the separator (SPR') overlapping with the emission unit (EU), and has a width that gradually decreases in a direction from the base electrode (666a) toward the separator (SPR').

13. The display device (10) of claim 11 or claim 12, wherein:
(i) the protruding electrode (666b) has a triangular cross-section; and/or
(ii) the protruding electrode (666b) has a sharp end protruding toward the emission unit (EU).

14. The display device (10) of any one of claims 11 to 13, wherein the separator (SPR') has a width (W) of about 80 nm to about 200 nm.

15. An electronic device comprising:
a display device (10) according to any one of claims 1 to 14 for providing a display screen, optionally wherein the electronic device (50) is a smartphone, a tablet PC, a laptop computer, a TV, a desktop monitor, smart glasses, a smart watch, a head-mounted display, or a display for vehicles.
